# EUROPEAN PATENT SPECIFICATION

(11) **EP 0 573 503 B1**
(45) Date of publication and mention of the grant of the patent: **11.12.2002**
(21) Application number: 92905546.5
(22) Date of filing: 25.02.1992
(51) Int. Cl.: G06F 9/44, G06F 17/40, G01R 13/04, G01R 29/00, G01R 13/34

(54) **SCIENTIFIC INSTRUMENT EMULATOR**
WISSENSCHAFTLICHES EMULATORGERÄT
EMULATEUR D'INSTRUMENT SCIENTIFIQUE

(30) Priority: 28.02.1991 AU 486991
(43) Date of publication of application: 15.12.1993
(73) Proprietor: ASSOCIATIVE MEASUREMENT PTY. LTD., North ryde, NSW 2114 (AU)
(72) Inventor: WILLIAMS, Donald, Victor, Balmain, NSW 2041 (AU); KEEBLE, John, Brian, Neutral Bay, NSW 2089 (AU); OATES, John, David, Quakers Hill, NSW 2763 (AU); CAMPOS, Alejandro, Guillermo, North Rocks, NSW 2151 (AU)
(74) Representative: Altenburg, Udo, Dipl.-Phys.
(86) International application number: AU9200076
(87) International publication number: WO92015959

(56) References cited:
- EP-A- 0 351 961
- US-A- 4 064 394
- US-A- 4 315 315
- US-A- 4 507 740
- US-A- 4 868 785
- AMERICAN JOURNAL OF PHYSICS, AUG. 1989, USA, vol. 57, no. 8, ISSN 0002-9505, pages 741-746, XP002020430 WHITELEY R V ET AL: "An inexpensive, versatile experiment for teaching computer-aided experimentation"
- NORTHCON. CONFERENCE RECORD, SEATTLE, WA, USA, 9-11 OCT. 1990, 1990, LOS ANGELES, CA, USA, ELECTRON. CONVENTIONS MANAGE, USA, pages 353-358, XP002020431 TREAT H: "Using mathematica in support of LabVIEW: power in the laboratory"
- PC BUSINESS SOFTWARE, 1989, UK, vol. 14, no. 1, ISSN 0038-0652, pages 2-3, XP002020432 "LabVIEW Version 2.0"

## Description

The present invention relates to scientific instruments and, in particular, to an emulator which enables the function of various scientific instruments, when interconnected, to be emulated or replicated without the need to purchase, install, interconnect, and test, the various scientific instruments. In its preferred form, the present invention enables measurements to be taken, and the use of measurement processes, which were unable to be taken, and used, with the interconnected instruments.

### BACKGROUND ART

In many fields of activity having a scientific basis, scientific instruments are used to analyse, record, and monitor the outputs of various devices. Such devices include strain gauges, electro-cardiograph (ECG) devices, microphones, and pressure, temperature, flow rate and like transducers. Accordingly, such scientific instruments are used in civil engineering, electrical engineering, acoustics, hydraulic engineering, chemical processes, bio-medical engineering and so on.

A wide range of such scientific instruments are generally required in order to undertake desired measurements. Such instruments include generators for various wave-forms (such as sine, square, ramp, and triangle); signal processing devices such as differentiators, integrators, filters, multipliers, and so on; analysers such as that required to carry out the Fast Fourier Transform, and various recording devices such as a chart recorder, a data logger, a cathode ray oscilloscope or a transient recorder.

Such instruments or devices are each relatively expensive and thus any research institution, or like organisation only has a limited number of such devices. Accordingly, there is considerable competition amongst persons or groups within such organisations who wish to utilise the devices. Once the devices have been obtained in order to carry out the intended operation, it is necessary for the devices to be located together, interconnected, and tested in order to ensure that the interconnections are correct. Only once this procedure has been carried out is it then possible to commence the intended operation.

It is known in the art to provide instruments which are essentially highly advanced cathode ray oscilloscopes. One such instrument is sold under the name SUPERSCOPE by G W Instruments of Summerville Ma USA 02143 and enables waveforms captured by what is essentially a storage oscilloscope to also be displayed on an APPLE (Registered Trade Mark) MacIntosh (Registered Trade Mark) Computer. However, this device does not appear to emulate instruments, rather it only captures and stores for subsequent display the output of such instruments.

It is also known to utilise software for data acquisition. One such program offered by LABTECH of Willmington, Ma and San Francisco, California, USA is a graphical interface which again accepts signals from various hardware items external to the computer. The software collects data from multiple channels, carries out an analysis and, if necessary a reduction of the data and produces displays. This activity is available in real-time. Again, no attempt is made to emulate the function of scientific instruments. A further difference is that the graphical interface connects to a number of different machines, rather than being essentially integrated into one unit.

A data acquisition and analysis system sold under the trade name LABVIEW2 by National Instruments of Austin, Texas, USA is also known. In this system, icons are used to represent both data acquisition functions and data analysis functions. These icons are used to generate executable code which is only executed by the personal computer into which the software of the system is loaded. This system uses no hardware, only software. The data acquisition and analysis functions can be sequentially linked so that data input into the computer can be first acquired and then analysed. Finally the analysed data is presented. It is to be noted that the computer functions to make desired inter-connections between external instruments but does not emulate instruments or compile a program to replicate the signal processing functions of an array of inter-connected instruments. For example, no provision for feedback from one icon back to another in the control sense, is made. The slow processing speeds, and the indetermine nature of the multi-tasking environment of the APPLE (Registered Trade Mark) personal computer, require the provision of a time "co-ordinate" to accompany the acquired data.

This system is a virtual instrument which is to say it is characterised by software simulation only and is to be contrasted with the new concept of emulation. Emulation involves flexible, multipurpose, re-programmable hardware which executes code derived from a graphic compilier at a fast operating speed which enables real time instrument emulation.

US 4,315,315 relates to a process for automatically producing a computer program in machine assembly language directly from a two-dimensional network representing the flow of data and control logic which it is desired to accomplish on a specified general purpose digital computer. However, emulation is not performed.

The article "Using Mathematica in Support of LabView: Power in the Laboratory", NORTHCON Conf. Rec. Seattle, WA, USA, 9-11, Oct. 1990, pp. 353.358, relates to a graphics oriented computer language for creating programs which are executed on personal computer. There is no emulation performed.

Therefore, the object of the present invention is to provide a scientific instrument emulator and a corresponding method which reproduce the function of scientific instruments. This object is achieved by the emulator according to claim 1 and by the method according to claim 8, respectively. Further embodiments are defined in the dependent claims.

The task of the emulator is to reproduce by means of a combination of both hardware and software, the functions of various scientific instruments thereby enabling not only the individual functions of the instruments to be replicated, but for such replicated functions to be interconnected with each other so that the emulator as a whole can replicate the overall function of an array formed by interconnected scientific instruments.

A number of very substantial advantages are attained thereby. Firstly, the overall cost of the apparatus is substantially reduced since the individual scientific instruments the functions of which are to be replicated, need not be purchased. Secondly, a substantial saving in set up time is also achieved since it is not necessary for such instruments to be bought from various locations and assembled at the one point and physically interconnected with wiring, plugs, adaptors, and so on. Thirdly, the results achieved are much improved in that the output of the array of interconnected scientific instruments is not only able to be displayed in real time, but it is, in addition, processed in real time and is also able to be stored for subsequent manipulation, analysis and evaluation. Finally, the results of simultaneous or parallel measurements can be more easily associated so that the interrelationships between measurements can be ascertained, particularly in complex systems.

The invention is set out in appended apparatus claim 1 and method claim 8.

Preferably the instrumentation units are each represented by a corresponding icon which is able to be displayed on the video display screen during the operation of the set-up program to enable the operator to select, and locate in the array, the desired instrumentation unit.

The compiler generates in the memory a number of different programs representing the array of instrumentation units. These programs are distributed to the processor in the computer system to emulate the desired array of instrumentation units. Preferably, the compiler generated programs are stored in memory to create preconfigured instrumentation arrays instantly capable of executing desired processing functions. These programs store the accumulated intellectual product of the user.

Preferably the number of processors, video generators and analog signal modules is expandable to obtain the desired degree of complexity and/or capability of the array of instrumentation units.

The analogue signal module has available a real time electric signal which can be used to operate, or trigger, other items of hardware. Preferably it also provides both analogue and digital output.

The input/output from the scientific instrument emulator is preferably also available from other resources available within the computer including network communications interfaces (RS232, ETHERNET etc) and bus interfaces such as IEEE-488-GPIB, ISA and EISA. These resources can be provided independently by the purchaser or original equipment manufacturers ( OEM's).

The data stored in the memory means is also preferably available for data "export" to various standard computer packages such as those sold under the trade marks EXCEL, LOTUS and AXUM whereby the data accumulated can be manipulated for subsequent graphical presentation and tabulation to facilitate report generation.

According to a second aspect of the present invention there is disclosed a scientific instrument for measuring and recording electrical waveforms, said instrument comprising a computer having a central processing unit and electronic memory means positioned within a housing, said housing including provision for at least one floppy disc nacelle; and a plurality of electrical connectors accommodated in the space allocated for said one floppy disc nacelle, said electrical connectors being connected to said memory means.

According to a third aspect of the present invention there is disclosed a compilation method for generating object code to implement the mathematical/signal processing function of an electrical circuit functional block having at least one input to form an output thereof, said method comprising the steps of representing said function as a sequence of elemental mathematical steps each of which is itself directly representable in said object code, and arranging the object code steps in said sequence for sequential execution commencing with said input(s). Preferably a parameter of said functional block is able to be specified. Also disclosed is a compilation method for generating object code to implement the mathematical/signal processing function of an electrical circuit having at least one input and at least one output and formed by interconnection of a plurality of functional blocks each of which has a mathematical/signal processing function for which an object code has been compiled in accordance with the above, said method comprising the steps of representing the electrical circuit mathematical/signal processing function as a sequence of events each of which is representable in said object code, and arranging said object code events in said sequence for sequential execution commencing with said input(s).

### DESCRIPTION OF THE DRAWINGS

An embodiment of the present invention will now be described with reference to the drawings in which:
Fig. 1 is a schematic block diagram of the hardware modifications required to an IBM PC,
Fig. 2 is a block diagram of the analogue module of Fig. 1,
Fig. 3 is a circuit diagram of one of the identical relays of Fig. 2,
Fig. 4 is a schematic map of the memory arrangement within the computer,
Fig. 5 is a block diagram of the real time video printed circuit board of Fig. 4,
Fig. 6 is a screen display listing the icons representing the various instrumentation units stored within the library program,
Fig. 7 is a typical array formed by inter-connection of the various instrumentation units,
Fig. 8 is a block diagram of a relatively straight forward array useful in bio-medical applications,
Fig. 9 is a reproduction of the screen display windows corresponding to the array of Fig. 8.
Fig. 10 is an array which forms a linear interpolation,
Fig. 11. shows the output of the three screen displays illustrated in Fig. 10.
Fig. 12 is an array which forms a phase locked loop,
Fig. 13 shows the output of the three screen displays illustrated in Fig. 12,
Fig. 14 is an array which provides an analogue solution to a second order differential equation,
Fig. 15 shows the output of the two screen displays illustrated in Fig. 14, and
Fig. 16 is a more complex array.

Appendices I-IV list various program fragments described hereafter.

### DESCRIPTION OF THE PREFERRED EMBODIMENT

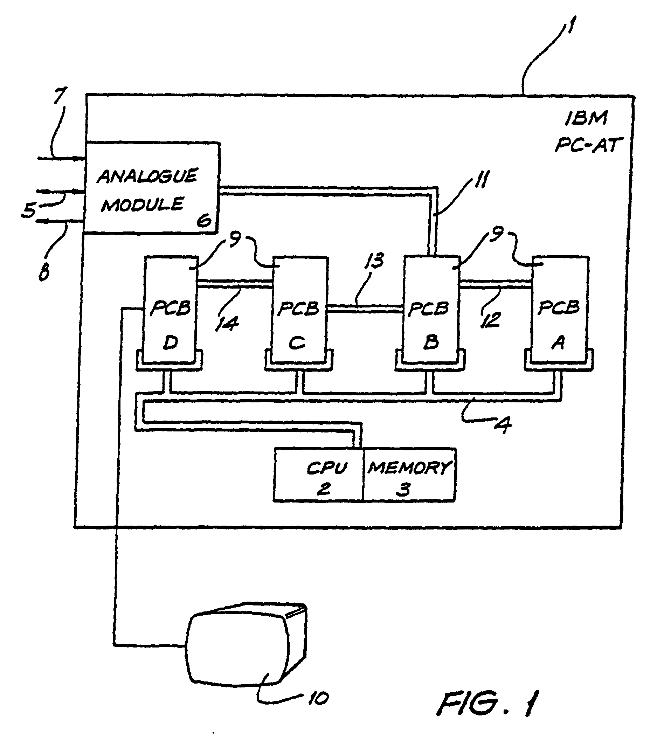

Turning now to Fig. 1, the apparatus of the preferred embodiment is able to be totally enclosed within the case 1 of a conventional IBM (Registered Trade Mark) Personal Computer having an ISA or EISA bus based on the original IBM AT. Located within the case 1 are the,usual components of a central processing unit (CPU) 2, memory 3 and 8MHz bus 4.

Located within a spare 5¹/₄ inch floppy disc nacelle is an analogue module 6 onto which are mounted dedicated input plugs 7, dedicated output plugs 8, and general input/output lines 5 for amplifiers, frequency counters, sample clock synchronising, digital inputs and the like.

Located on the bus 4 are four slots for printed circuit boards 9. The four PC boards 9 are indicated A, B, C and D respectively. The three adjacent PCB's A to C inclusive are respectively a master PCB, a slave PCB and a video PCB. The video PCB in turn drives a known VGA printed circuit board D sold by Tseng Labs which can provide 800 x 600 resolution in 256 colours. This PC board D is directly connected to the video display screen 10.

Within the analogue module 6 are located the following system resources:
1 FOUR isolated (optional) analog i/p channels. Each channel has programmable 9-120dB gain (3 micro volts resolution @ signal to noise ratio of one), programmable anti-alias filtering and an ADC conversion of 12 bit resolution. Each channel can be AC or DC coupled with long AC coupling time constants (2 minutes) and has independent controls of AC or DC offsets which can be controlled from the runtime screens. The sampling rate can be 15 KHz per channel (depending on the project processing load) and the number of analog modules attached to the same slave processor card. The inputs are isolated to 3.5KV continuous.
2 TWO analog outputs with a voltage range of +/-10 Volts and a current capacity of +/- 100mA. These can be used for strain gauge biasing (AC or DC driven), control outputs etc.
3 FOUR selectable high level analogue outputs, one from each of the amplifiers above. These drive digital FM tape recorders to store rarely occurring events for replay into the processor (2).
   OR
   FOUR selectable high level inputs to each of the amplifier channels above. The system is switched into this mode for replay of events captured in output mode on tape.
4 EIGHT bits of ground referenced digital input.
5 EIGHT bits of digital output which can be used for relay drivers or event indicators.
6 ONE frequency generator output (clock generator) 0-2 MHz 0.1% accuracy.
7 ONE event counter/frequency counter. Input 0.1Hz-8MHz.
8 ONE 5 Volt reference 100mA +/- 5%. (For strain gauges etc.)
9 ONE sample clock output reference line for synchronising sampling between multiple scientific instrument emulators of the preferred embodiment.
10 ONE sample clock input reference line for synchronising sampling from a "master" scientific instrument emulator (for use with "slave" emulators), and
11 FIVE ground wires.

The analogue module 6 and PC boards 9 are each interconnected by means of different subsidiary buses 11, 12, 13 and 14 respectively.

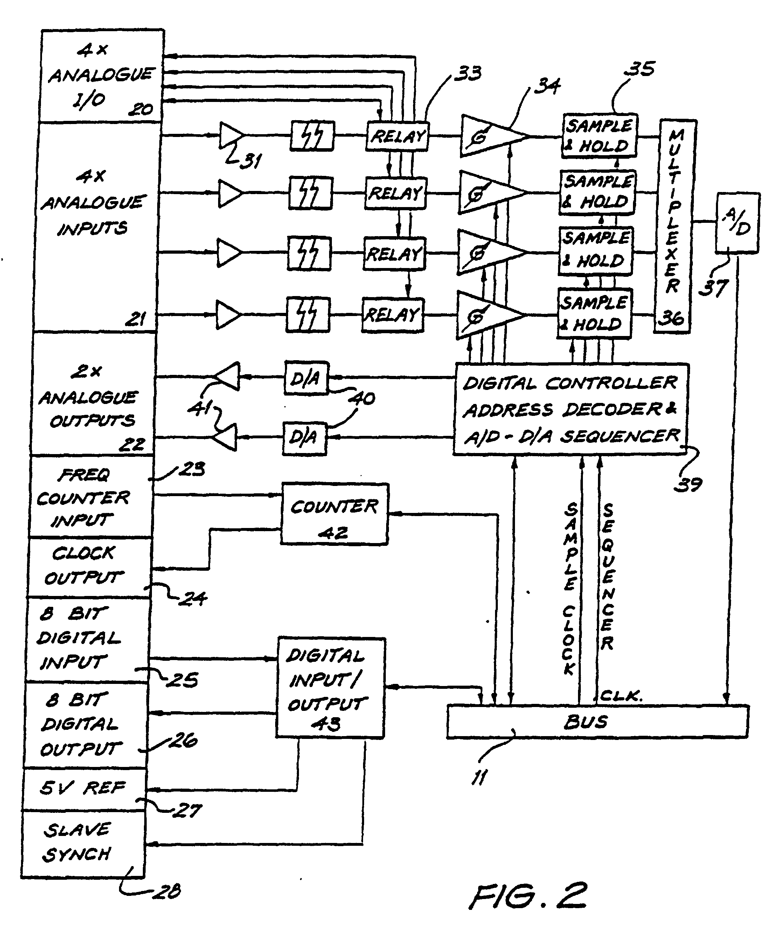

As seen in Fig. 2, the analogue module 6 of Fig. 1 is provided with four analogue input/output connectors 20, four analogue inputs 21, two analogue outputs 22, a frequency output counter input 23, a clock output 24, an 8 bit digital input 25, an 8 bit digital output 26, a five volt reference voltage 27 and a slave synchronizing output 28.

Each of the analogue inputs 21 is connected via a front end amplifier 31 to an isolator 32, the output of which is connected to a relay 33. The relay 33 is also connected to the analogue input/output connectors 20 and to an amplifier 34 which has programmable gain. AC/DC coupling, provision for an AC corner and DC offset. The output of the amplifier 34 is in turn passed to a sample and hold circuit 35 the output of which is received by an analogue multiplexer 36. The output of the multiplexer 36 is passed via an AID converter 37 to the subsidiary bus 11 which connects the analogue modules 6 and the PC board 9B.

The operation of the amplifiers 34 and the sample and hold circuits 35 is controlled by a digital controller, address decoder and A/D-D/A sequencer 39 which receives both data from the bus 11 and also sample clock and sequencer clock signals. The controller/decoder/sequencer 39 also outputs via D/A converters 40 to the analogue outputs 22 via an output amplifier 41.

The frequency counter input 23 and clock output 24 respectively directly communicate with a counter 42 which again communicates directly with the subsidiary bus 11.

Each of the digital inputs 25, digital outputs 26, reference voltage 27 and slave synchronizing output 28 is connected to a digital input/output circuit 43 which is in turn directly connected to the subsidiary bus 11.

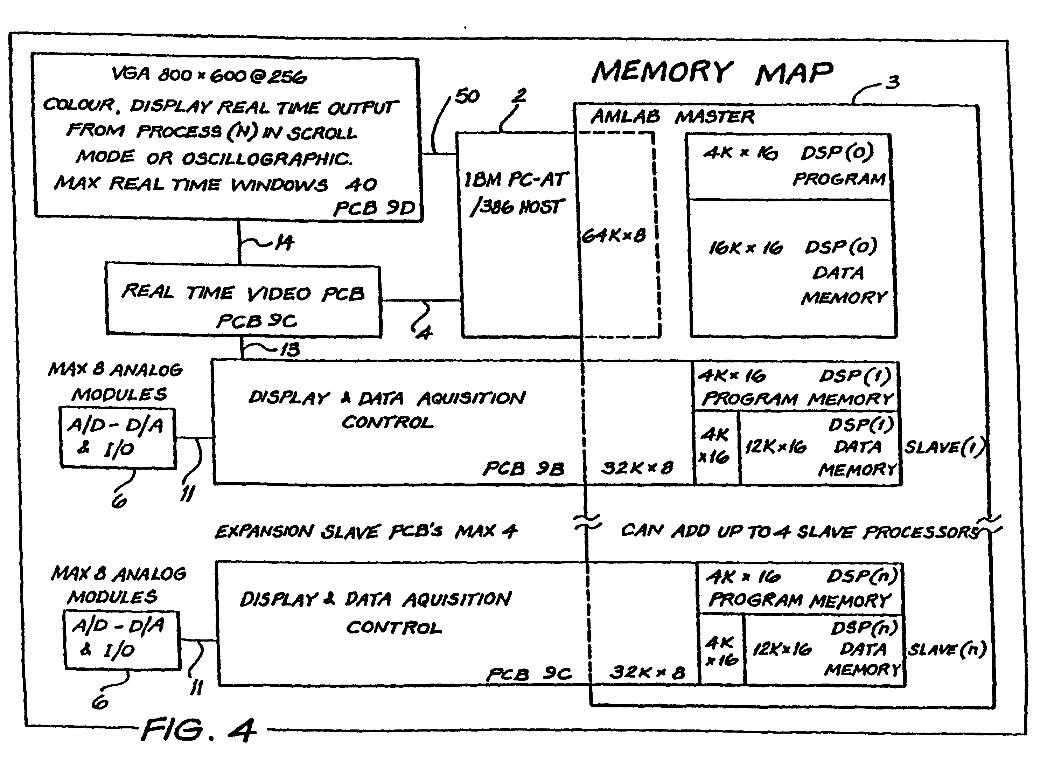

The timing arrangements of the circuit illustrated in Fig. 2 are divided into two sequences. The first sequence concerns the digital input and output. When required by the program, this digital input and output is effected by individual commands from a substantially conventional data acquisition controller which forms part of the slave processor on PCB 9B (Fig. 1 and Fig. 4).

The second sequence is the flow of digital data converted from the analogue inputs, or to be converted to provide the analog outputs. This digital data is received and despatched under the control of the controller/decoder/sequencer 39 which can be preset to operate the required number of incoming and outgoing analogue channels. The controller/decocer/sequencer 39 performs one complete cycle of inputting and outputting, or sequence, every sample period and does so with minimal processor involvement, thus increasing the speed of operation of the data acquisition controller referred to above on the slave processor of PCB 9B.

Other functions of the circuit of Fig. 2, such as the frequency to be output as the clock output 24, the "range" of the frequency to be counted by the frequency counter input 23, and any synchronisation signal required for the slave synchronising signal 28, are set up at the start of the execution of the graphical compiler program by appropriately specifying the corresponding icon.

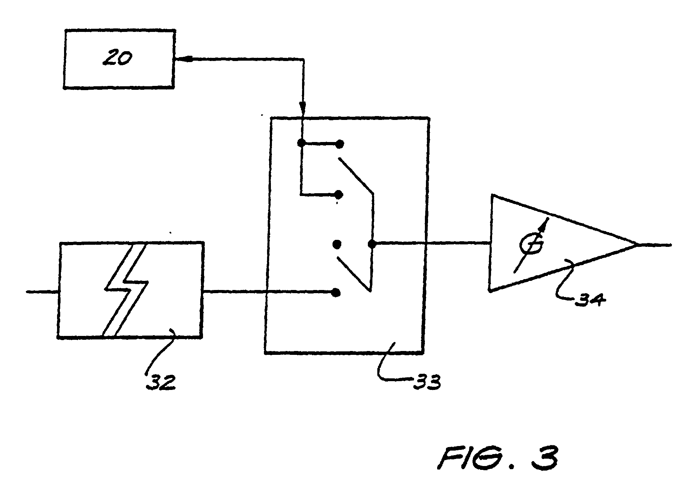

Fig. 3 illustrates in detail the nature of the relay 33 which can be switched between two positions. In the position shown, the input from the analogue input/output 20 is passed to the amplifier 34, thereby isolating the analogue inputs 21. In the alternative position, the input from the analogue inputs 21 is passed to the amplifier 34 but is also made available as an output at the analogue input/output 20.

Fig. 4 is a pictorial representation of the processor architecture and includes a memory map. The host computer 2 with its associated memory 3 is connected to the video PCB 9C which is in turn connected to the slave PCB 98.

As indicated in Fig. 4, up to 8 analogue modules 6 are able to be connected to each PCB 9B and up to four slave PCB's 9B can be added.

The memory map is essentially three dimensional with the memory 3 of the host computer 2 overlying, and thereby being accessible to, the other memory utilising portions of the circuit.

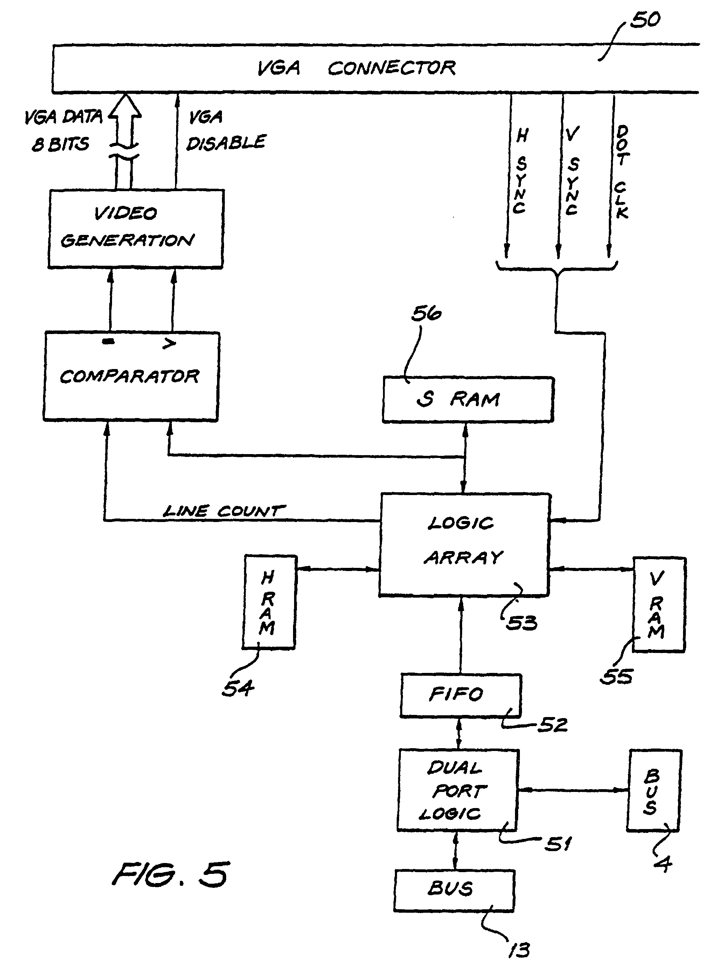

A block diagram of the video PCB 9C is illustrated in Fig. 5. In this diagram the interconnections between the conventional video graphics adaptor (VGA) of the host computer are made via the conventional VGA connector 50. The connections between the host computer 2 and the video PCB 9C are via bus 4. Similarly the connections between the video PCB 9C and each of the slave PCB's 9B is via bus 13 as previously indicated in Fig. 1.

Data received from either bus 4 and/or 13 is passed via a dual port logic circuit 51 to a first in first out (FIFO) buffer 52. The FIFO 52 outputs to a logic array circuit 53 which has three separate random access memories, horizontal RAM 54, vertical RAM 55 and a static RAM 56.

The output of the logic array 53 is passed via comparator 57 to a video generator 58 and thence to the VGA connector 50. In addition, the logic array 53 also receives three signals from the VGA connector in the form of horizontal synchronizing pulses, vertical synchronizing pulses and a dot clock.

Essentially the logic array 53 takes the data supplied via buses 4 and/or 13 and calculates pixels to replace the individual pixels generated by the video graphics adaptor (VGA) 12 and complies with multimedia standards for communication of the video image on bus 14.

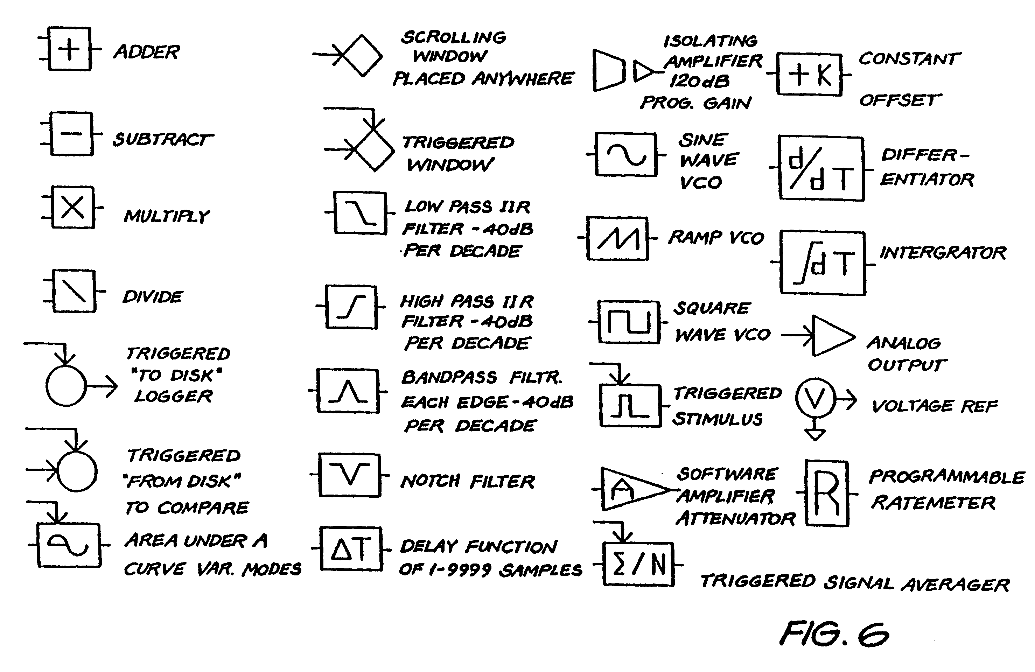

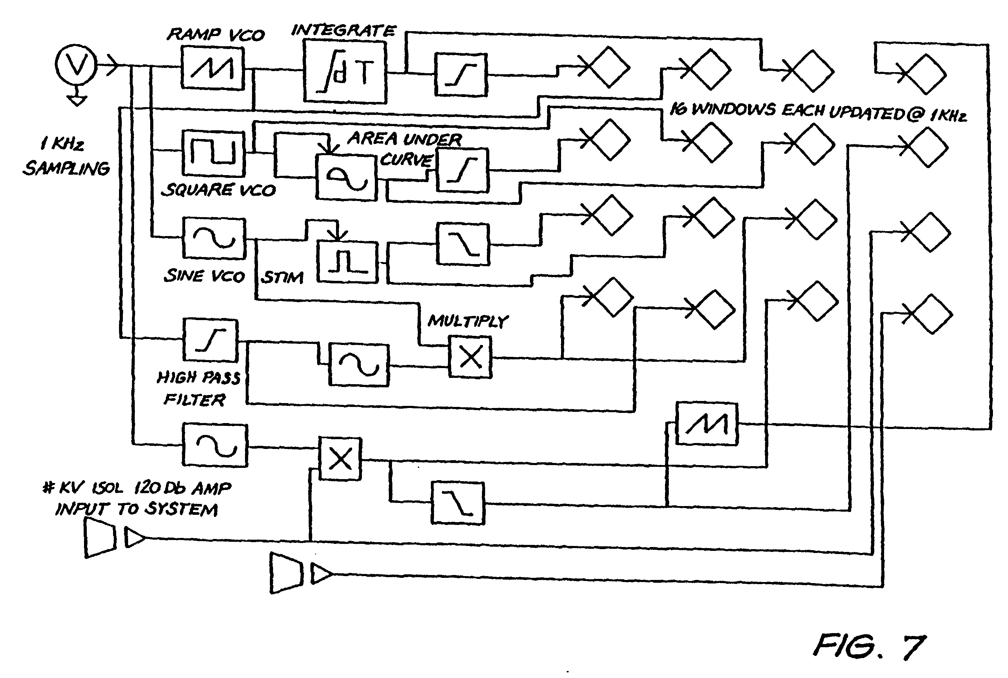

The memory 3 (Figs. 1 and 4) has a library of instrumentation units. Each of these is represented by an icon and Fig. 6 provides an indication of the range of instrumentation units able to be selected from a given library. By use of a mouse in known fashion, the operator is able to interconnect selected instrumentation units from the icon list of Fig. 6 so as to form an array of interconnected instrumentation units as illustrated in Fig. 7. During the course of the creation of the array of Fig. 7, under software control the machine checks that the array does not have any unconnected inputs, logically unacceptable connections, and like defects. Any detected defect is indicated.

Once the array has been interconnected to the satisfaction both of the operator and the set-up program used during this phase, a compiler program is then run which compiles from the graphical representation of the array the executable object code which executes the overall signal processing function for the entire array. As a consequence, when, in real time, the input signal is applied to the array, the incoming signal(s) is/are manipulated and the one or more outputs of the array are indicated in real time on the video windows able to be displayed on the screen 10, stored to disc, and so on.

Essential to an understanding of the way in which the compiler program operates is an appreciation that each icon is itself a mini array which can be built up from very fundamental steps which are themselves easily executed by the program. For example, if the basic steps are taken to be addition and subtraction, then multiplication can be regarded as repeated addition, and division can be regarded as repeated subtraction. With this background in mind, it can be appreciated that a ramp voltage generator can be created from a zero initial level by the successive additions of very small increments until a predetermined level is reached. Then that level is itself subtracted so as to re-create the zero starting point. Then the small additions are again made, and so on.

A consideration of the various icons represented in Fig. 3 will also lead to the appreciation that the icon is itself essentially a graphical form of any desired shape designed to convey a representation of a specific mathematical or signal processing function which is both seen by the user and identically understood by the graphical compiler program. The shape contains at least one input node and/or at least one output node these being respectively the entry and exit points for data streams. For example, an adder having input nodes A and B and output node C is compiled to give the program C = A + B. Those icon elements having only one or more output nodes are termed source icon elements (eg a voltage generator) whilst those icons having only one or more input nodes are termed a destination icon (eg a display window).

Interconnecting any output node and terminating at an input node is a connecting path termed a data stream. The data stream carries the data type associated with the output node and, as a consequence, the input node at which it terminates must be of the same data type. This provides an additional rule inherent within the compiler program. Since the interconnections between nodes represent data streams, rather than physical wiring, it is permissable for the interconnections between icons to cross over other interconnections or even other icons without ill effect. This is because the data stream has an output node and an input node and is unconcerned with any intermediate location. The co-ordinates of the source and destination nodes on an arbitary co-ordinate system are used to create the software "pointers" to source and destination data buffers for the execution of the signal processing functions on the data "pointed" to.

Also included with an icon is an icon specification where the icon itself is insufficient to describe the entire function of the icon. For example, an amplifier has a function, output = G x input, where G is the gain of the amplifier. However, in order to enable the gain to be specified by the user, the gain is able to be input as a predetermined parameter by means of the icon specification.

It will be seen that using the above methodology, a library of prepared icons each with its own program to carry out the mathematical/signal processing function of the icon can be prepared. Furthermore, the same methodology is again applied once it is desired to compile a program to carry out the mathematical/signal processing functions of an array formed from Inter-connected icons. To take a simple example of an array, consider an array having two inputs A and B and an output C, the array consisting of an adder having inputs A and B, the output of the adder being connected to an amplifier having a gain G with the output of the amplifier constituting the output of the array. The mathematical/signal processing function is C = G x (A + B). The graphic compiler of the preferred embodiment creates machine code in the same way as would a FORTRAN compiler when it was presented with substantially the same statement but present in source code written in the FORTRAN language.

Appendix I constitutes a program fragment of code which permits the user to decide what the icon specification will be for the given icon. The "pop-up" window portion of the display into which the user inputs the numerical value(s) to be specified is termed a "sheet".

Similarly the program fragment of Appendix II is an example of the programming used in compiling an icon. The code used in compiling an array is analogous.

Appendix III is a code fragment which is an example of the digital signal processing (DSP) implementation code. This code enables digital signals which replicate the output of actual electronic devices (as represented by an icon or array) to be created.

Finally, Appendix IV is a code fragment of the timing or sequencing used in the digital signal processing. This ensures the timely completion of the calculations in the time between successive samples.

The operation in "real time" is assisted by the way in which analogue input signals are acquired. The permissable +/- 10 V input range is represented by a 12 bit number and the analogue input signal is sampled at a sampling frequency of from 1 to 60,000 points or samples per second. The exact sampling frequency is specified or selectable by the user. As a consequence of this sampling regime, all the programming steps required to emulate the particular function of an icon or an array are required to be completed, and thus create an output, in the time available between sampling points. In this way, the output for a given sampling point is calculated and hence created, prior to the receipt of the information for the next sampling point. This procedure enables real time operation with the proviso that if the calculation time exceeds the sampling period then either additional computer resources in the form of extra processor and/or memory must be provided to reduce the calculation time, or the sampling frequency must be reduced, thereby increasing the time for calculation. The increasing processing power of modern computers means that, in practice, any limitation to the sampling frequency is not of practical concern.

It will also be appreciated in connection with the above that the calculation to be performed by the computer can include feedback of an output at one sample time which then constitutes an the input for a subsequent calculation at the next sample time. The subsequent calculation must, however, be completed within the sampling period.

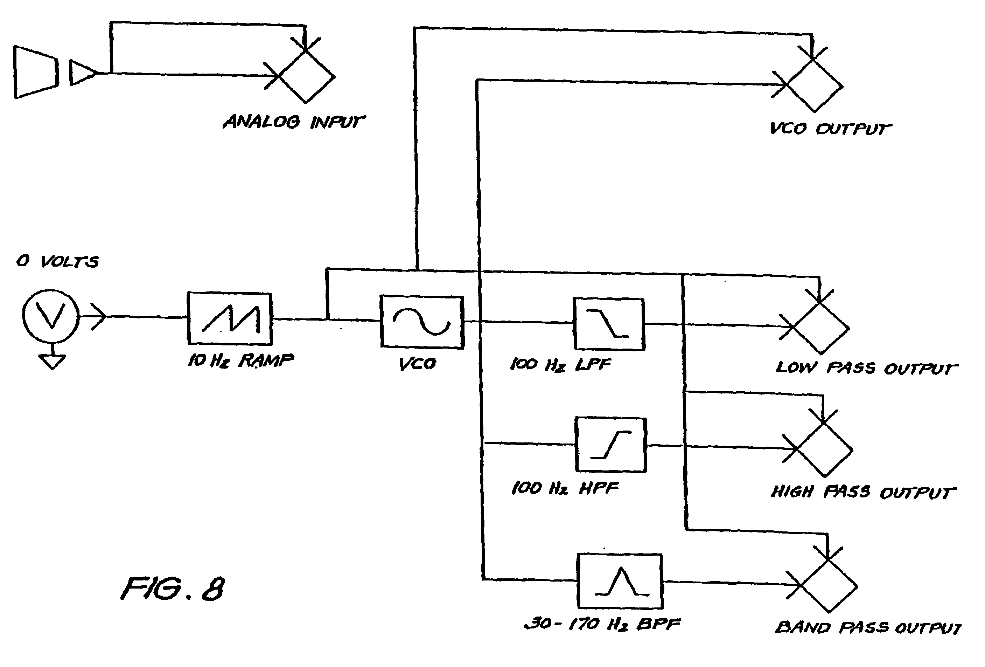

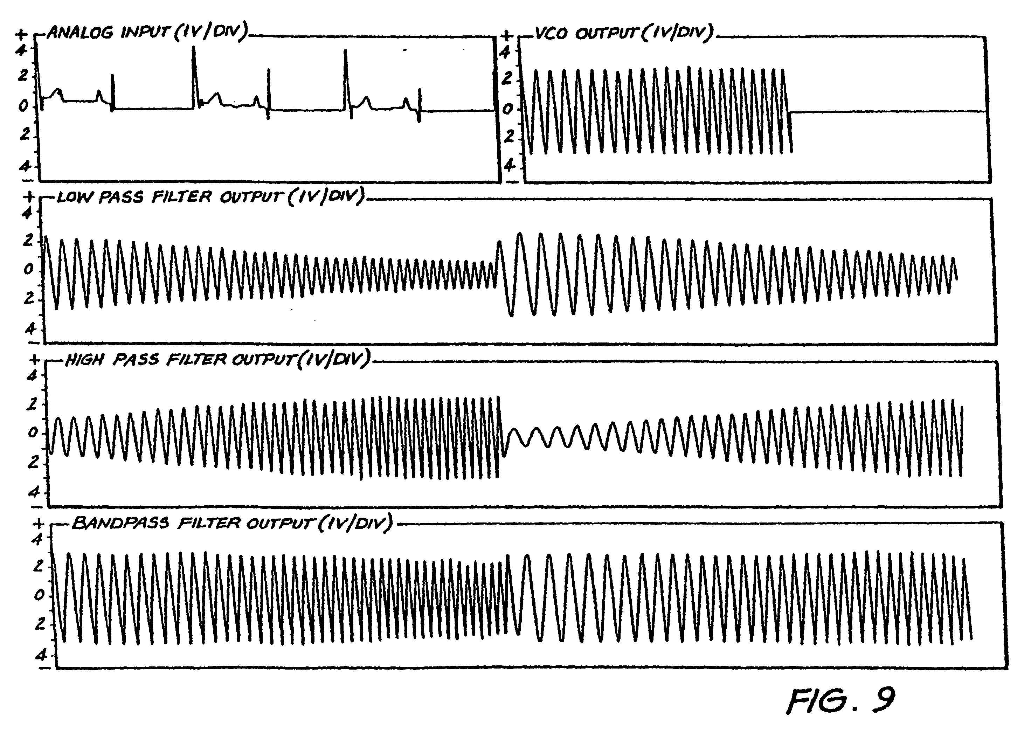

Fig. 8 illustrates two relatively simple arrays. The input and output waveforms to, and from, those arrays are respectively illustrated in Fig. 9. It will be seen that the input and output of the first array comprises an analogue voltage from an ECG. For the other array, the four outputs comprise the output of the voltage controlled oscillator, and that output when respectively passed through a low pass filter, a high pass filter and a band pass filter. Note that since the arrays are not in any way related, although all the waveforms can be simultaneously generated and/or displayed, it is not necessary for the results to be linked in any way.

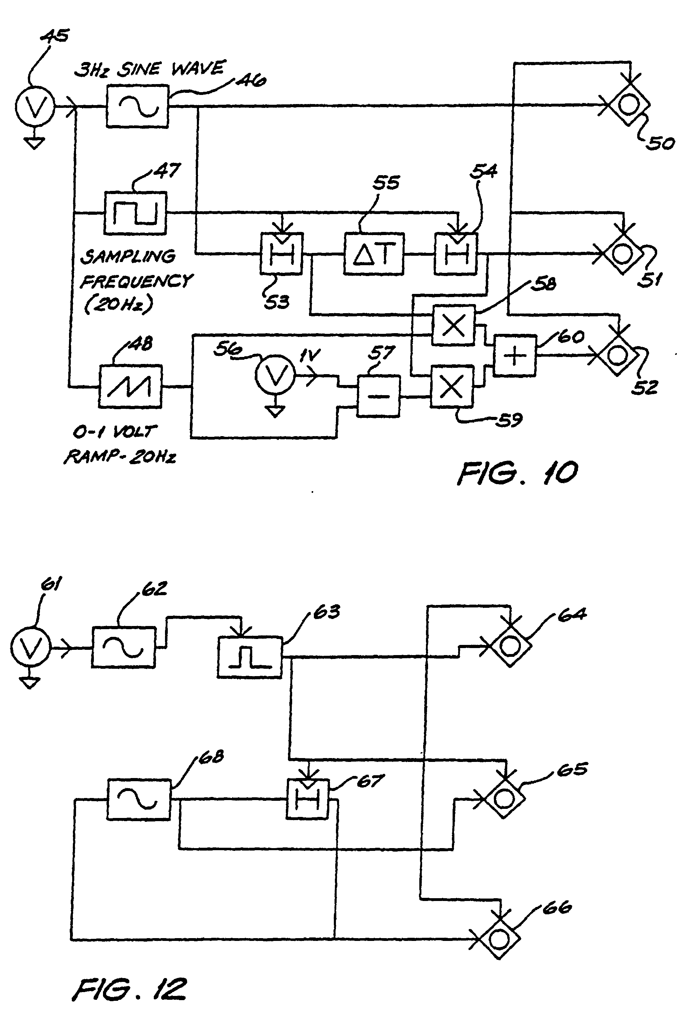

Turning now to Fig. 10, this drawing illustrates the array able to be first drawn and then compiled to emulate a linear interpolation circuit. A constant voltage source 45 is applied as an input to three voltage controlled oscillators 46-48 which respectively have a sine-wave output, a square-wave output and a ramp output. The output of the sine-wave is set at 3Hz whilst the output of the other two generators 47 and 48 is set at the sampling frequency of 20Hz. The output of the sine-wave oscillator 46 is used to trigger each of three displays 50-52. The output of the square-wave oscillator 47 is used to trigger two sample and hold circuits 53, 54 which are separated by a time delay circuit 55 having a delay which is approximately equal to the period of the sampling. This ensures that the outputs of the two sample and hold circuits 53, 54 represent the results of successive samples.

A further voltage reference 56 is set at one volt and comprises one input to a subtractor 57. The linear interpolation is carried out by the two multipliers 58, 59 and the adder 60. The multipliers multiply the ramp gradient by the correct proportion determined by the amplitude differences of successive samples held in circuits 53, 54.

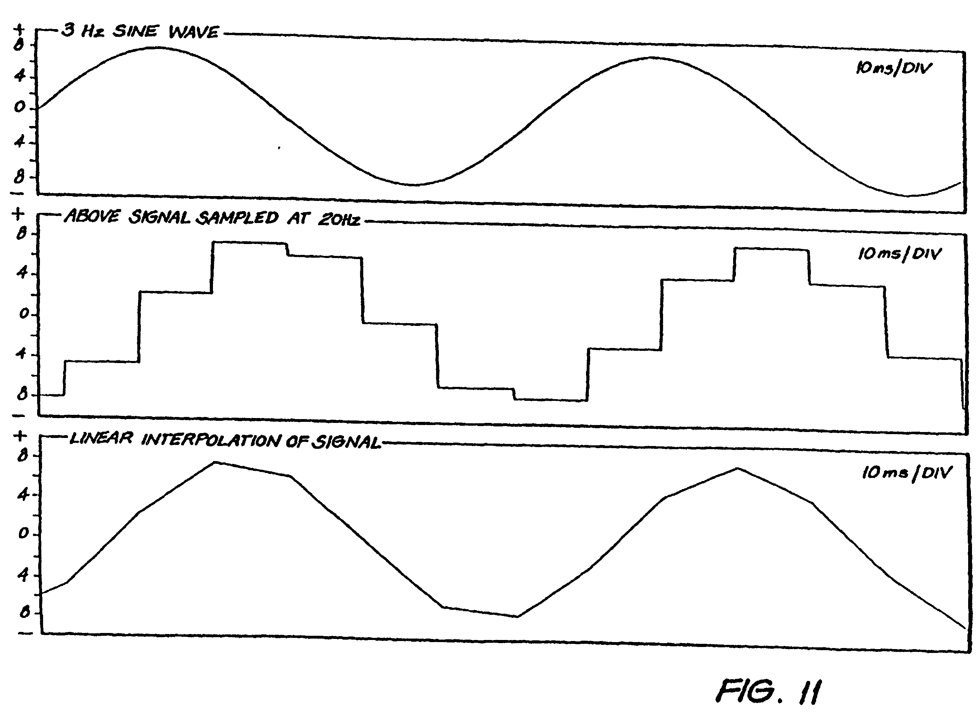

The "input" sine-wave at 3Hz which constitutes the screen display 50 is illustrated in Fig. 11 as is the sampled sine-wave which constitutes the display 51. The linear interpolation created from the sampled sine-wave constitutes the display 52 and is also illustrated in Fig. 11.

Fig. 12 illustrates an array which constitutes a phase locked loop. Again, a voltage reference 61 constitutes the input of a voltage controlled sine-wave oscillator 62, the reference voltage of 61 being set so as to set the frequency produced by the oscillator 62 at 51Hz. The output of the oscillators 62 is used to trigger a pulse circuit 63. The output of the pulse circuit in turn triggers three displays 64-66 and constitutes the display signal for display 64.

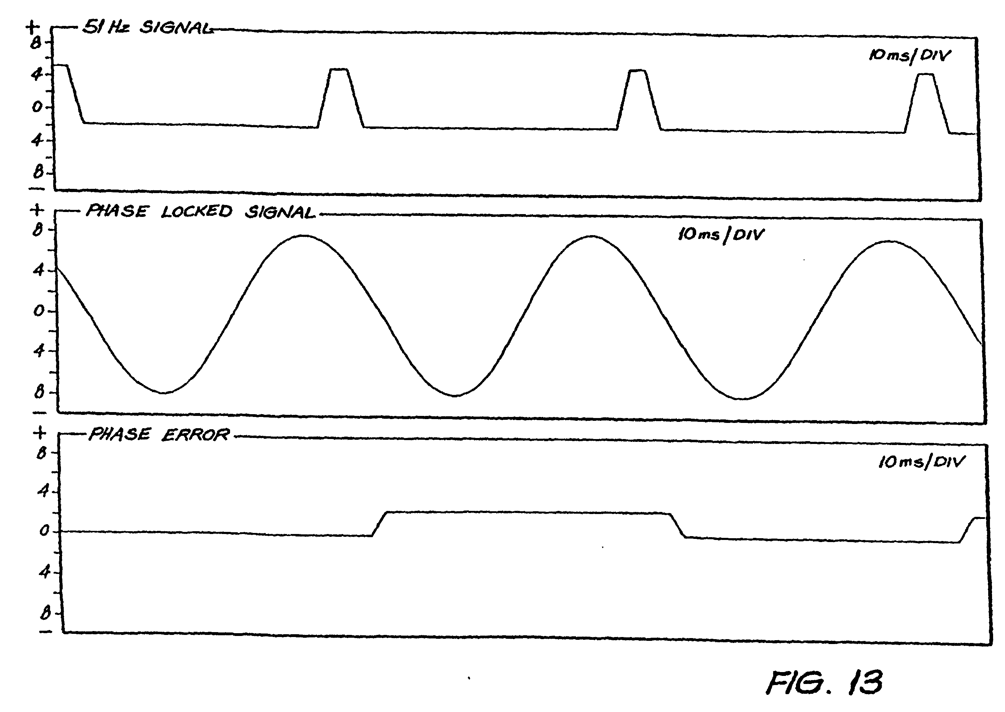

In addition, the output of the pulse circuit 63 is used to trigger a sample and hold circuit 67 which has an input formed from the output of a voltage controlled sine-wave oscillator 68 which is set to have a centre frequency of 50Hz. The input to the voltage control oscillator 68 constitutes the output of the sample and hold circuit 67 which essentially represents the phase difference between the signals from the oscillators 68 and pulse circuit 63. This error signal is displayed by display 66, the output of the voltage control oscillator 68 being displayed by display 65. The three displays 64, 65 and 66 of Fig. 12 are respectively illustrated in Fig. 13.

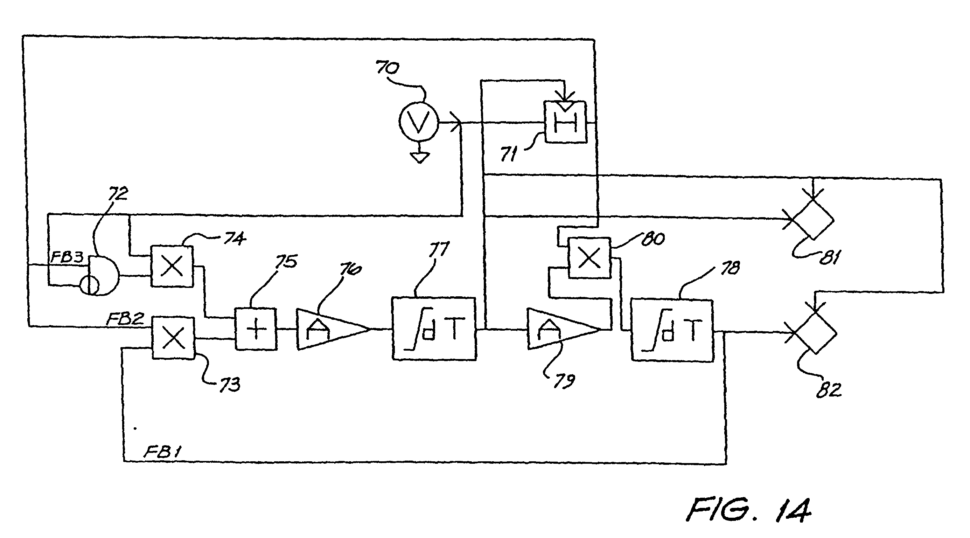

An array to solve a second order differential equation is illustrated in Fig. 14. Here three feedback loops FB1 - FB3 are provided. In order to set the initial conditions, a voltage reference 70 set to one volt is used to provide an input to a sample and hold circuit 71 and the inverting input of a comparator 72. The output of the sample and hold circuit 71 is fed back to the comparator 72 and also to one of two multipliers 73, 74. The output of the multipliers 73, 74 are added together in adder 75 and multiplied by the gain of amplifier 76 before being integrated by the first of two integrators 77, 78. A further amplifier 79 and multiplier 80 complete the circuit. The outputs of each of the integrators 77 and 78 form the waveforms displayed by two displays 81 and 82 which are both triggered by the output of the first integrator 77.

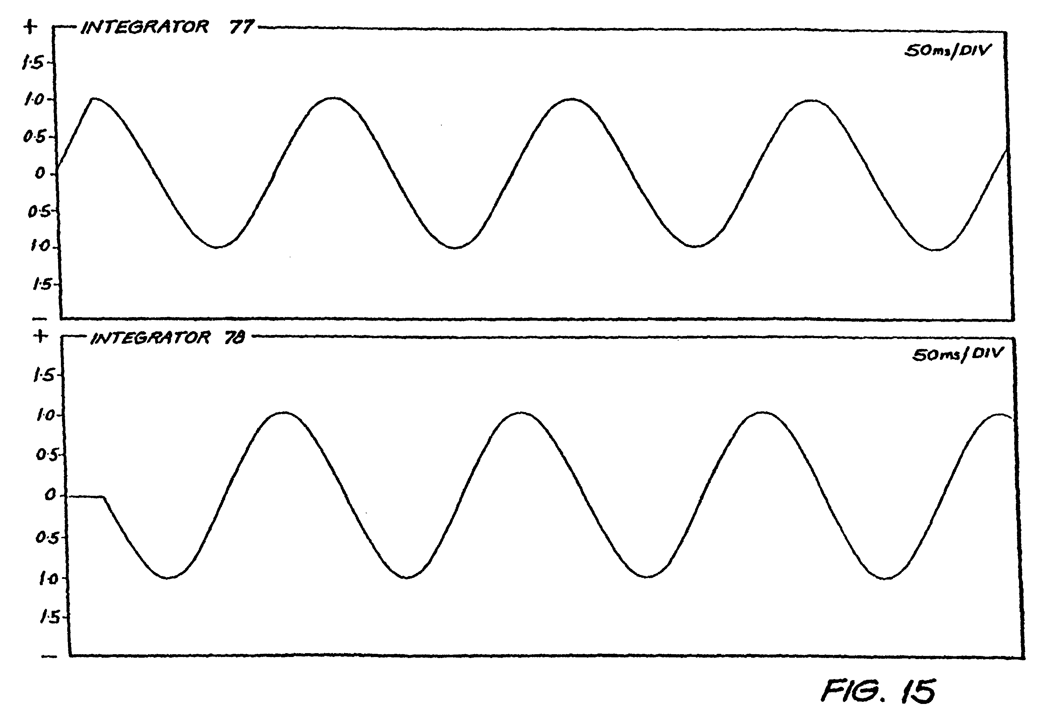

The results are illustrated on Fig. 15 and show both the initial solution corresponding to the initial conditions, and that the output constituting the solution of the differential equation runs indefinitely without apparent losses or gains within the limitation of quantizing errors. In an actual electronic circuit realisation to give effect to the solution of the second order differential equation, the use of real capacitors with losses, for example, would result in the progressive decay or growth of the output signal. However, with the above described arrangement because the solution is being continually calculated, there is no apparent decay, nor any unstable growth leading to saturation. This represents a substantial improvement over the prior art analogue computers.

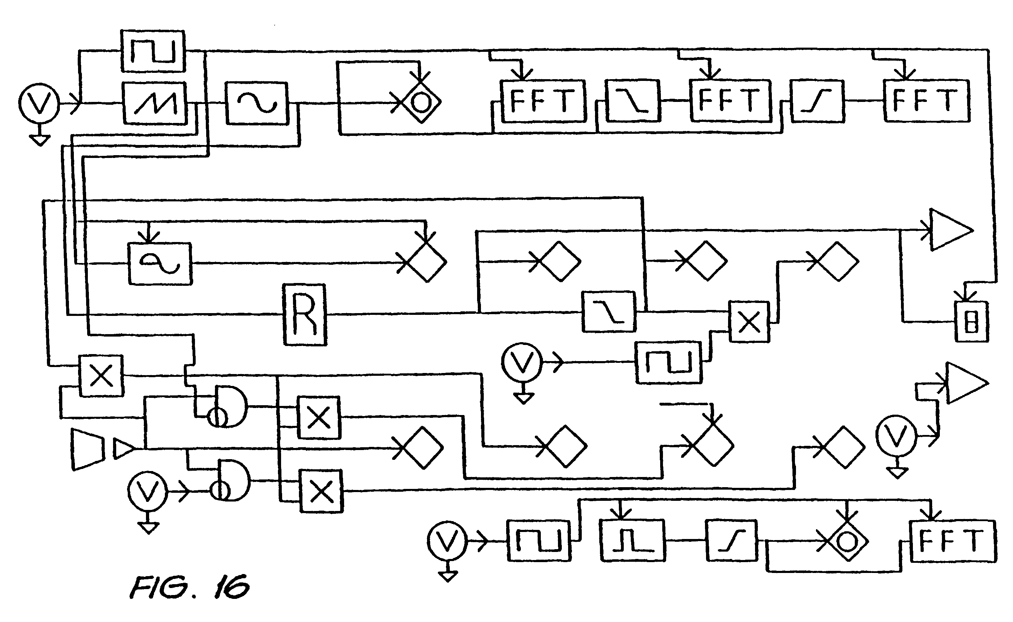

Fig. 16 is an example of a more complex array able to be compiled in accordance with the preferred embodiment of the present invention. It will be seen from Fig. 16 that four Fast Fourier Transforms, six different signal generators, numeric displays, bar charts, four reference voltages, four 40dB/decade filters, one "area under the curve" calculator and numerous comparators, multipliers, and the like are all provided.

Because the results, such as the waveforms illustrated in Fig. 6, are stored in memory, the user is able to replay these stored real time results. Furthermore, various portions of the results are able to be extracted for any specific purpose and even fed back into the apparatus using a "from disc" icon. This allows the signal processing to be adapted so that a desired feature of the input signal will be detected. Also the stored result can be continually replayed in real time, or faster or slower, as desired. Similarly, initial conditions can be established by using the previously stored result of a first array, as the initial input condition for a second array.

Furthermore, because the results are stored, the stored data is able to be edited and exported to spreadsheets, graphics or statistics utility programs such as EXCEL, LOTUS 123, and the like. This enables the graphical results of experiments to be combined with text describing the nature of the experiments and the nature of the conclusions.

The windows such as those indicated in Fig. 8, for example, are also compatible with multi media standards for the IBM PC. The specification for the window icon can be set up to be "PAL" which receives a conventional signal from a video camera, convert and then displays the video signal on the screen. If desired, this video signal can be frame grabbed to pixel video data which is able to be stored in the computer memory. If desired the conventional video camera signal can also be stored on a VCR at the same time. This stored video data can be replayed in the same manner as any other waveform captured by the apparatus. In this way, video picture correlation with other signal waveforms can be achieved. The time stamp placed on the conventional VCR video tape is, in this embodiment, synchronised with the signal data captured by the apparatus and stored therein. This arrangement is particularly advantageous since it enables the electrical results to be clearly identified with the optical record of the events which created the results.

The provision of icon specification means that the apparatus is particularly adaptive. For example, an array can be formed with a view to carrying out an analysis of, for example, the electrical voltages produced by the human heart. If as a result of the analysis of the results of these experiments, it is thought that a particular drug may produce some beneficial effect, then the array Itself need not be changed in order to permit the same measurement to be carried out on a rat to which the drug has been administered. All that is required to be changed is the specification of those icons which are used, for example, as a reference. For example, the actual voltage level and the frequency can be adjusted in order to account for the different electrical outputs (eg voltage levels and different pulse rates) between humans and rats.

Furthermore, the ability to create arrays at will means that the apparatus is able to measure the association or independence between signals and so add a further dimension to the results able to be achieved. For example, a heart rate can be correlated with, or multiplied by, a respiration rate of a patient to give a third signal which can be regarded as a signature signal representing a result of significance to the user. Many such signals, even of mixed units, can be associated in this manner, if necessary scaled appropriately, and then compared against past data stored in memory.

It will be apparent to those skilled in the art, that the above described system has integrated all functions that are required for an analog workstation. Hitherto, there has not been a completely integrated system. Instead a plethora of partial functions existed.

In particular the following features are component parts of the integrated whole of the scientific emulator of the preferred embodiment.
1 A multiple purpose/multifunction analog module which inputs/outputs digital and analog signals and other functions.
2 A "real time" video, both in PAL or picture form at the same time and waveform displays in up to 40 windows on one screen are available. The oscilloscopic displays (one kind of display methodology) are able to display sample rates of the order of 25KHz or better.
3 Signal processing is not controlled by a prose style (von Neuman) sequentially syntactic "line language" but by a simply understood and readily used parallel graphic compiler which is able to be used by non programmers.
4 Waveforms and graphic arrays in pictorial form are readily transported to existing PC tools such as wordprocessors, spreadsheets and "offline" analysis software for report generation/records etc.
5 Non volatile storage can be accessed in such a way as to be able to "source" data that is to be fed back into an array for other results. Also correlating a waveform template, stored on disc, against any incoming waveform to achieve shape detection is available. (Template matching).
6 Network compatability. The system is able to have ist various functions distributed over a network. That is, storage can be performed at the PC in an office, or waveform data can be sourced on one PC to be displayed on another. Also the program and data can be transported over the network to another similar scientific instrument emulator for analysis. The data and program are linked and are "bundled" for network transmission.

In its preferred form, the system takes the form of a signal processing device comprising proprietory hardware and software which is contained in an IBM PC with data acquisition amplifiers positioned in floppy disk nacelles and processor PCBs and real time video cards fitted onto the PC system bus. The device in one configuration contains an extra 2 ordinary General purpose processors and a further 2 signal processors. These combined processors are programmed by the use of a graphical compiler on the VGA screen in such a way that the PC host (operating at say three million instructions per second) views the resident device subsystem (operating say at fifteen million instructions per second) as an extension of its memory. All the other processors also see each other as extensions of their own memory. In this way the multitasking software can manage multiple processors with each task on the various processors communicating with the other task(s) and/or processor(s) by passing pointers to shared memory. Thus no special communications hardware or software is required. The graphical compiler which compiles executable object code for the installed subsystem, allows the rigorous use of mathematics which is processed so fast as to simulate real time with all necessary processing performed during a single sample time.

In addition to the functional adequacy of the programming system of the graphic compiler, the programming system using icons is constructed in such a way that compiled icons can themselves be composed of simple icons. This allows mathematical construction to be applied to two types of data streams involved with the processing. One of these types of data streams is the "acquired data stream" from the analogue to digital inter-conversion process and the other type is a "trigger stream". A trigger stream is some signal acquired from this inter-conversion and with which other signals which are desired to be displayed in time relationship, or is created by a timebase established in the array. Most often the trigger stream is created by a processing function wherein processing on one or many channels creates a signal which is intended to trigger displays, trigger processing such as averaging, or trigger storage. In general it is the complex trigger capability of the system, simply represented by the graphical compiler, which allows the accumulation of parameters which characterise various waveforms or epochs of waveforms. This allows their selection by experts to establish an "example set".

### INDUSTRIAL APPLICATION

The cost effectiveness of the apparatus of the preferred embodiment can be considered from the following. The apparatus can function as any one of the following devices, or any combination of the following devices (or multiples thereof) arranged together into an array.

| | DEVICE | COST A$ |
|---|---|---|
| 1 | 4 Channel Chart Recorder (500 Hz/channel) | 10,000 |
| 2 | FFT analyser (1Hz - 20KHz, max 512 points, 200 analyses sec.) | 13,000 |
| 3 | Frequency Counter (0.01% accuracy, 0.01 Hz - 10 MHz) | 1,000 |
| 4 | Function Generator (Sine, square, ramp, and triangle waveforms, 0.01Hz - 2MHz) | 5.000 |
| 5 | Data Logger (PC based) | 4,000 |
| 6 | Energy Monitor (Volts x Current, isolated inputs) | 4,000 |
| 7 | 2 Channel Transient Recorder | 3,500 |
| 8 | Electrophysiological Monitor (ECG, EEG, EMG, ERP) | 20,000 |

The above items of equipment constitute a cost of approximately A$60,500, however, the retail price of a scientific instrument emulator in accordance with the preferred embodiment and able to emulate the above functions is in the vicinity of A$15,000 (assuming the user has an appropriate personal computer to both receive the necessary hardware and run the necessary software).

Furthermore, the large number of parallel inputs in the integrated system is well suited to the study and analysis of parallel systems such as ecosystems, biosystems, machine systems, etc.

The foregoing describes only one embodiment of the present invention and modifications, obvious to those skilled in the art, can be made thereto without departing from the scope of the present invention.

### COPYRIGHT NOTICE

The program listings contained in Appendices I-IV are the subject of copyright owned by the applicant and are not to be reproduced In any way without the express prior written authority of the applicant.

### APPENDIX I

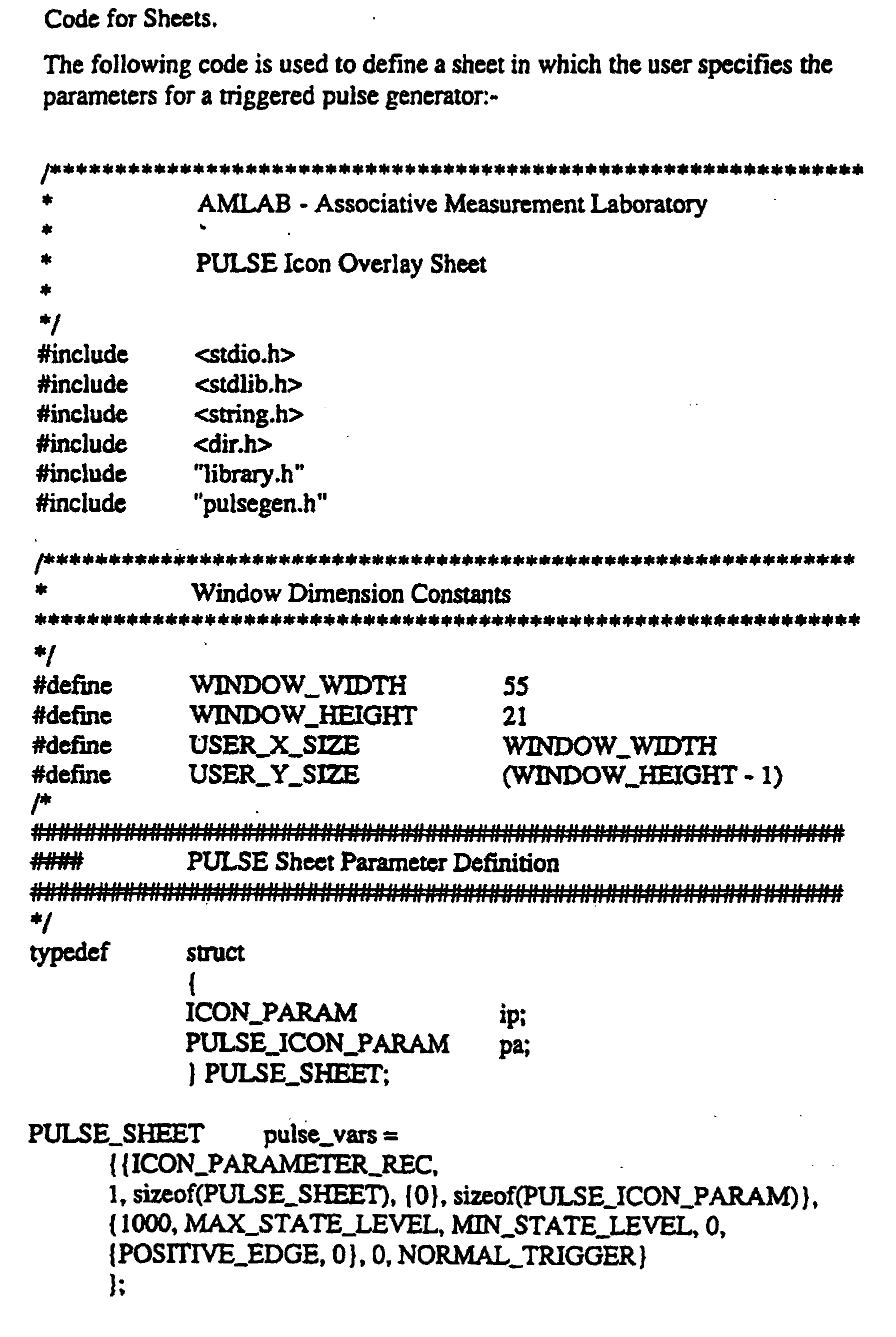

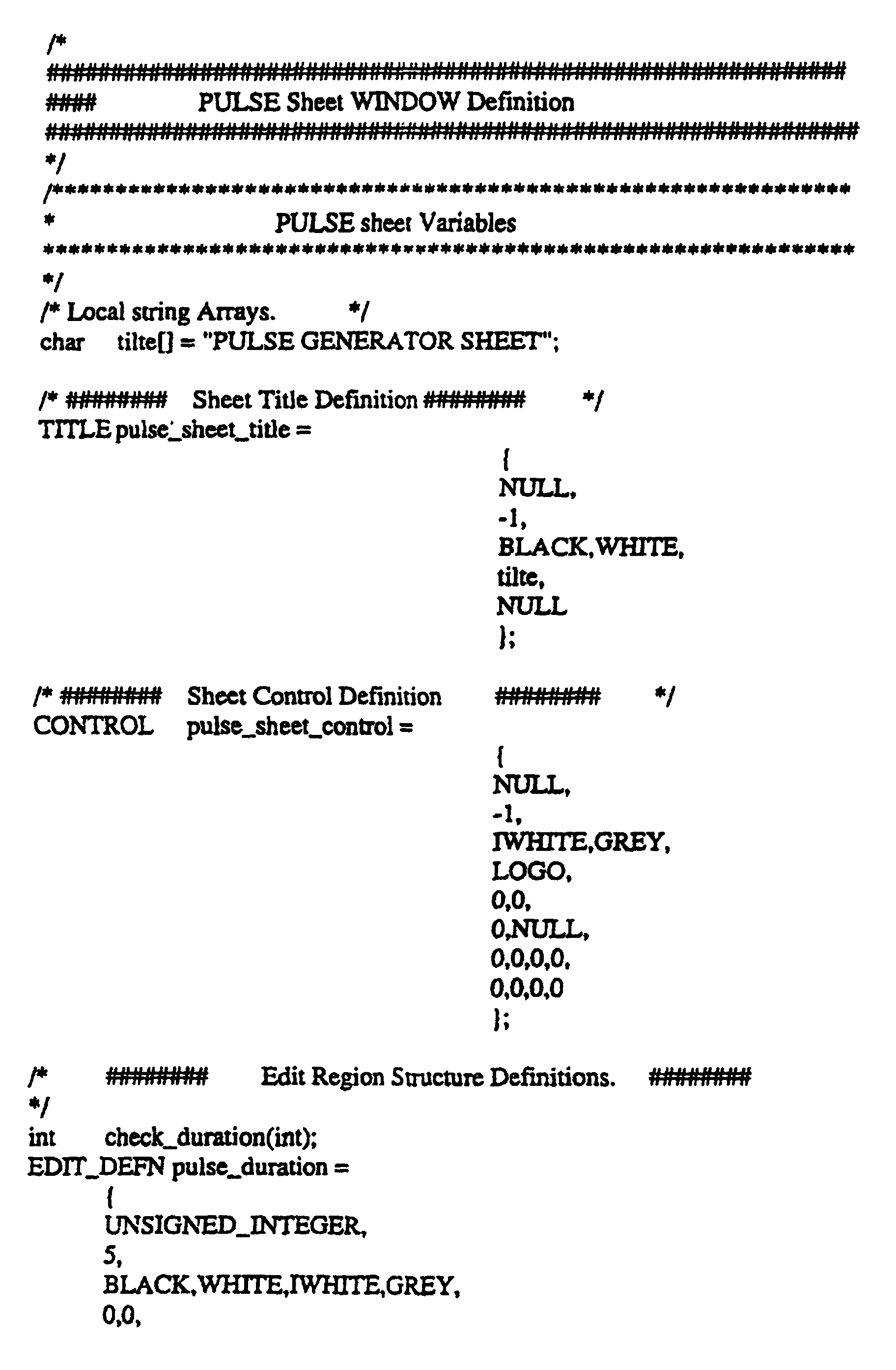

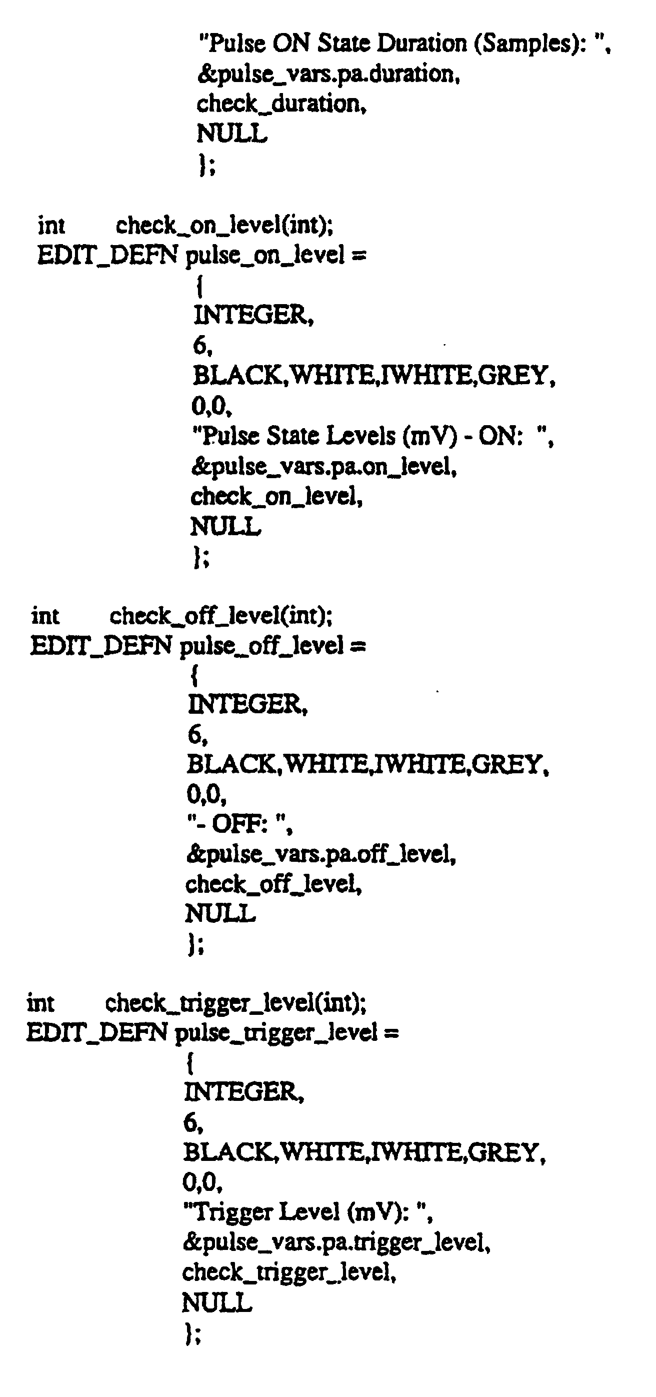

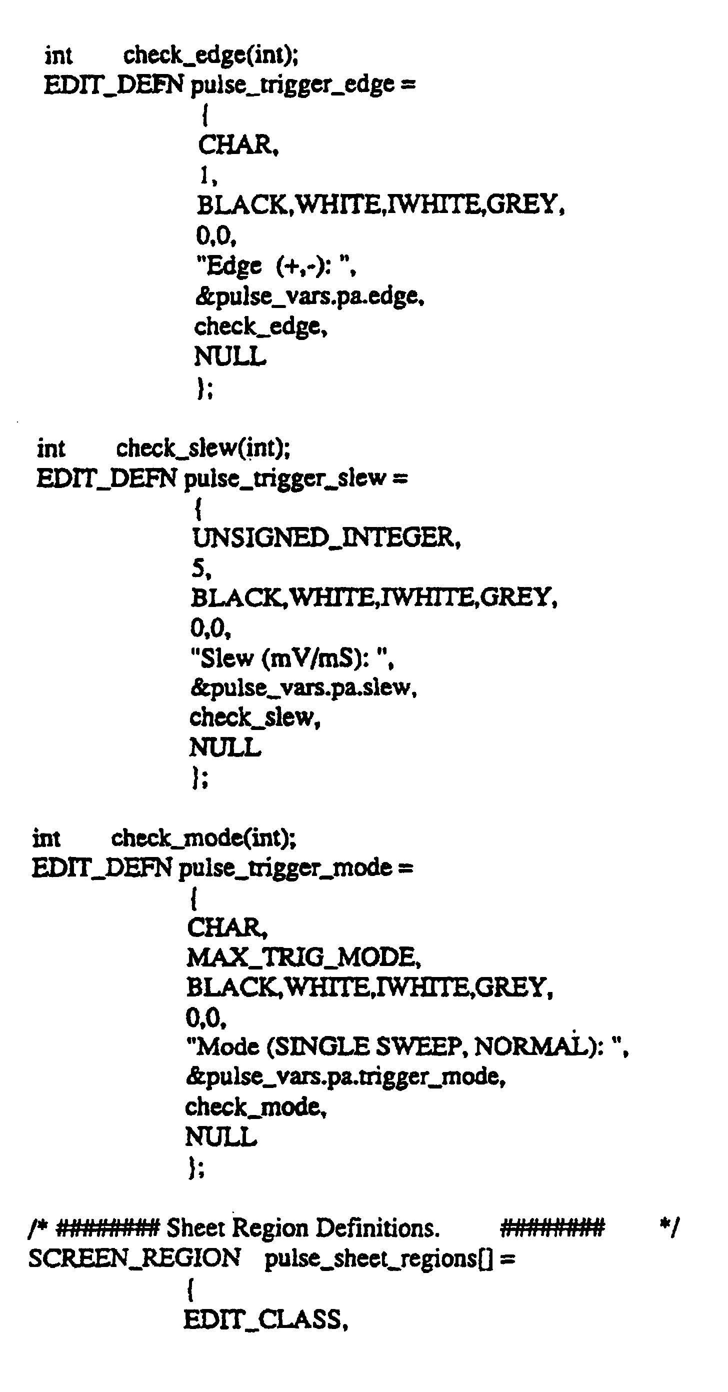

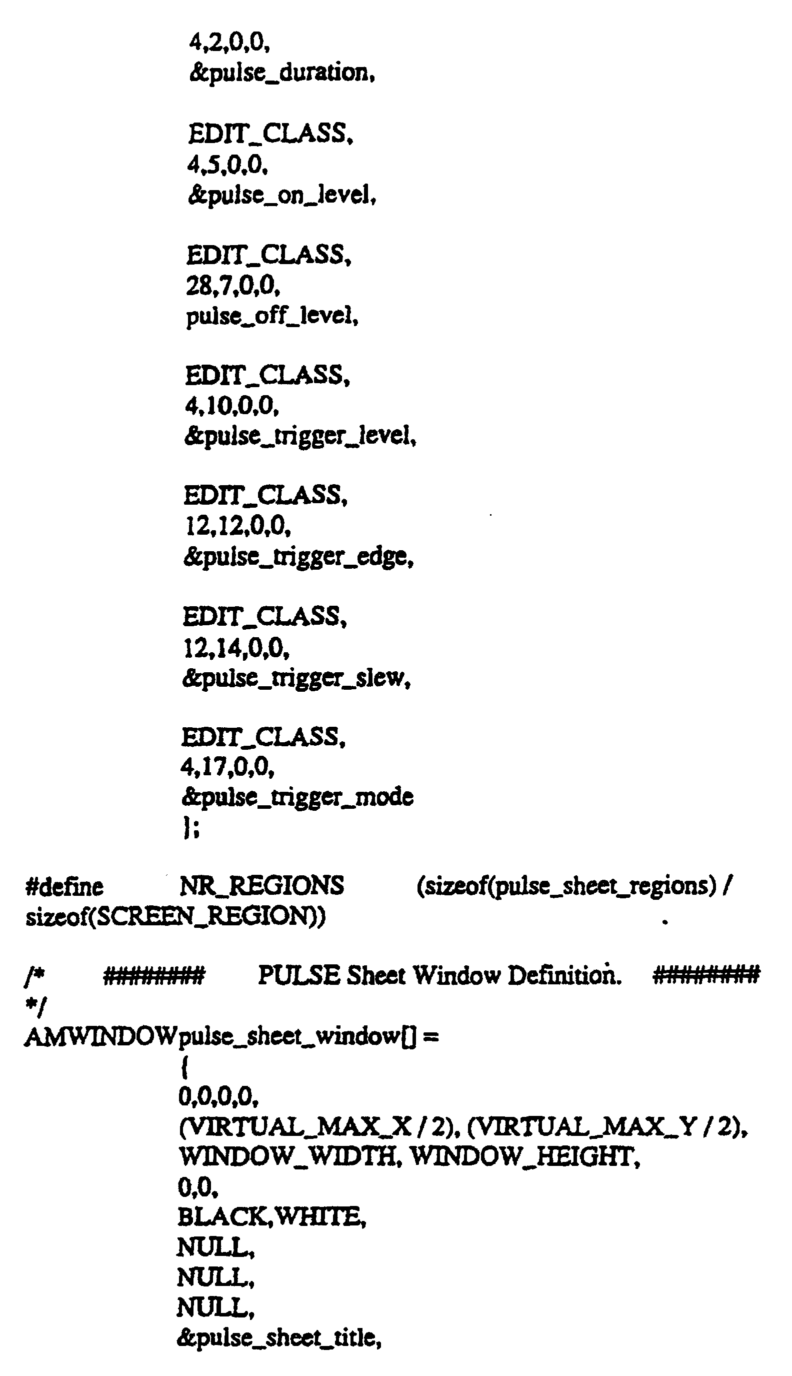

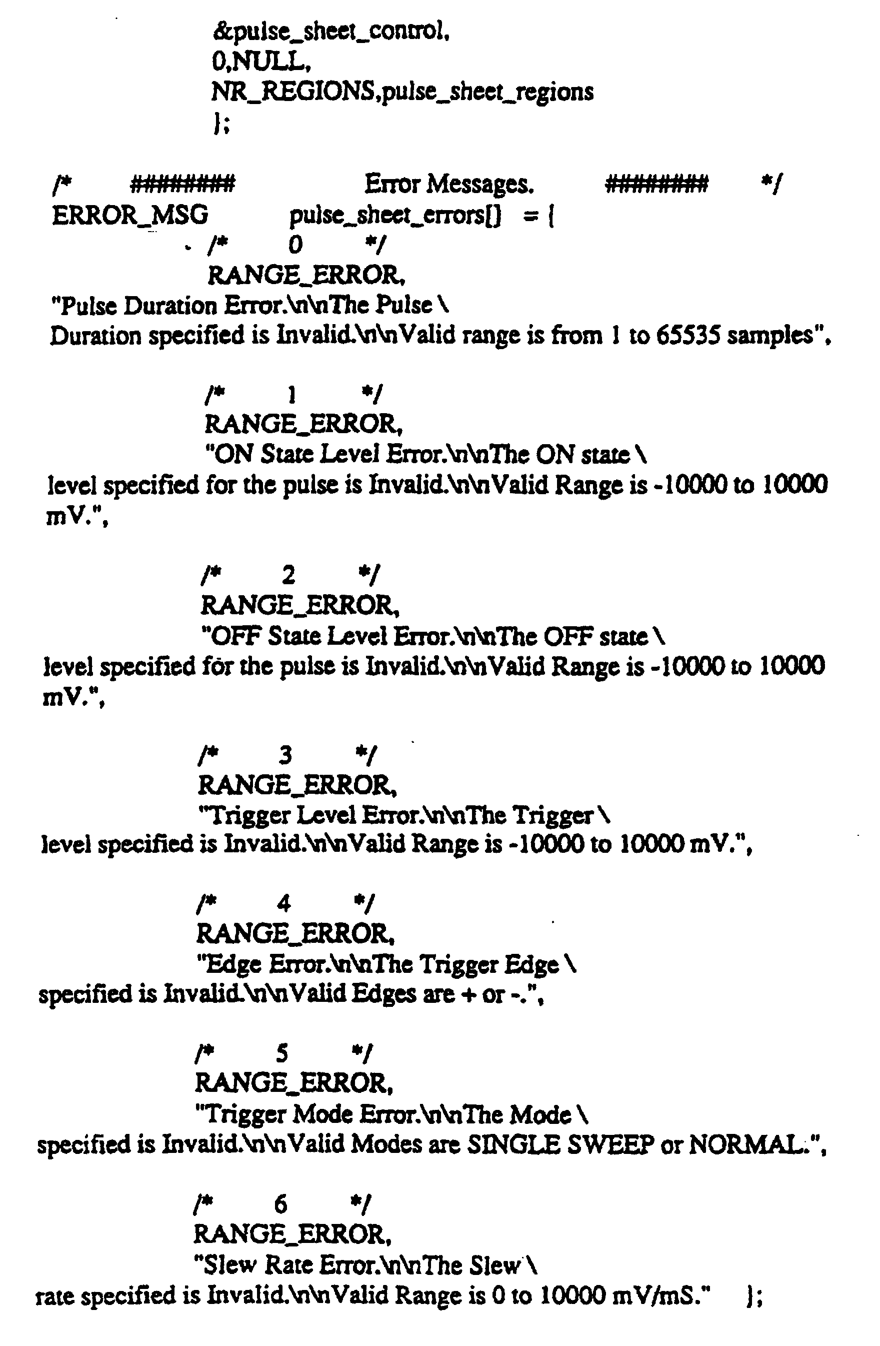

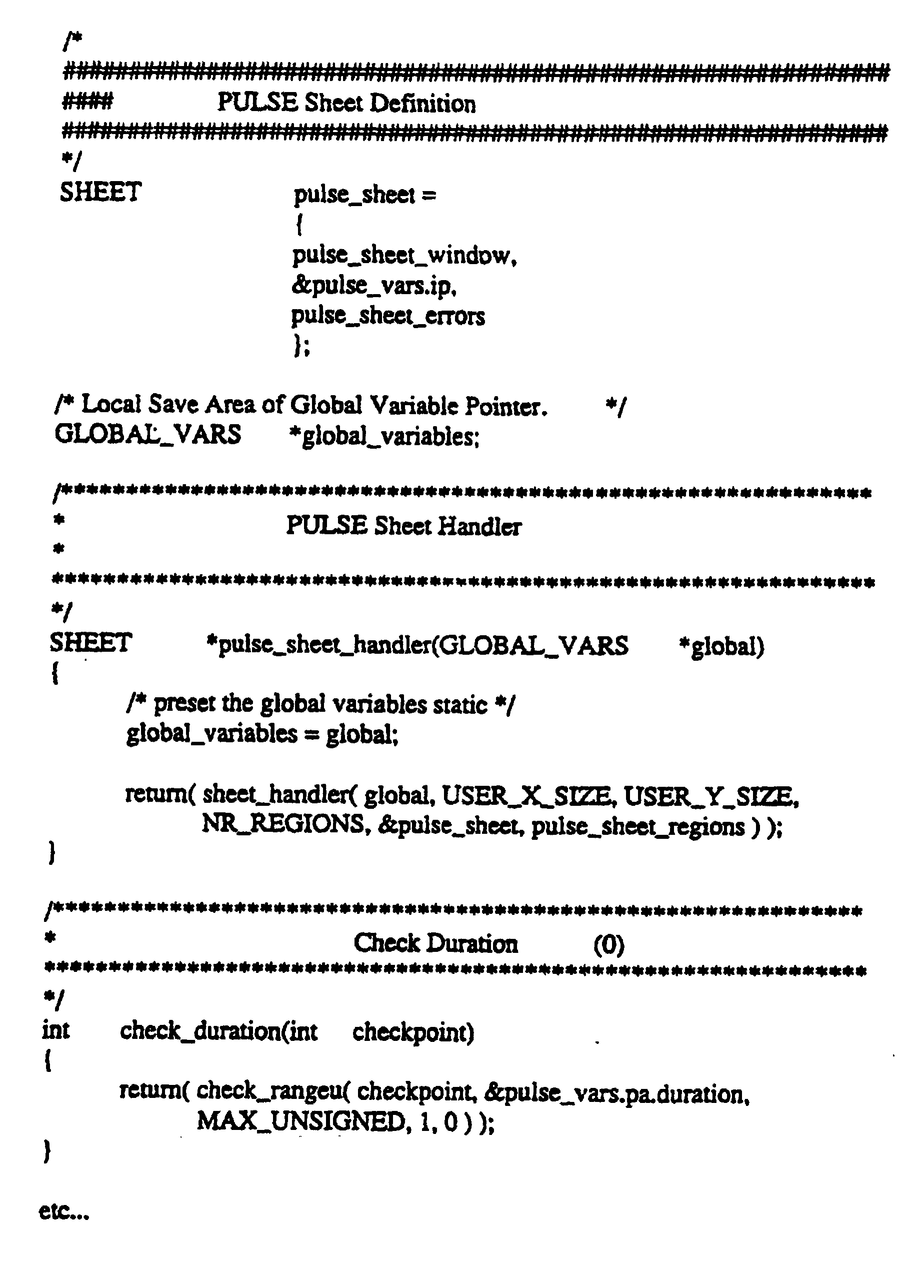

### APPENDIX II

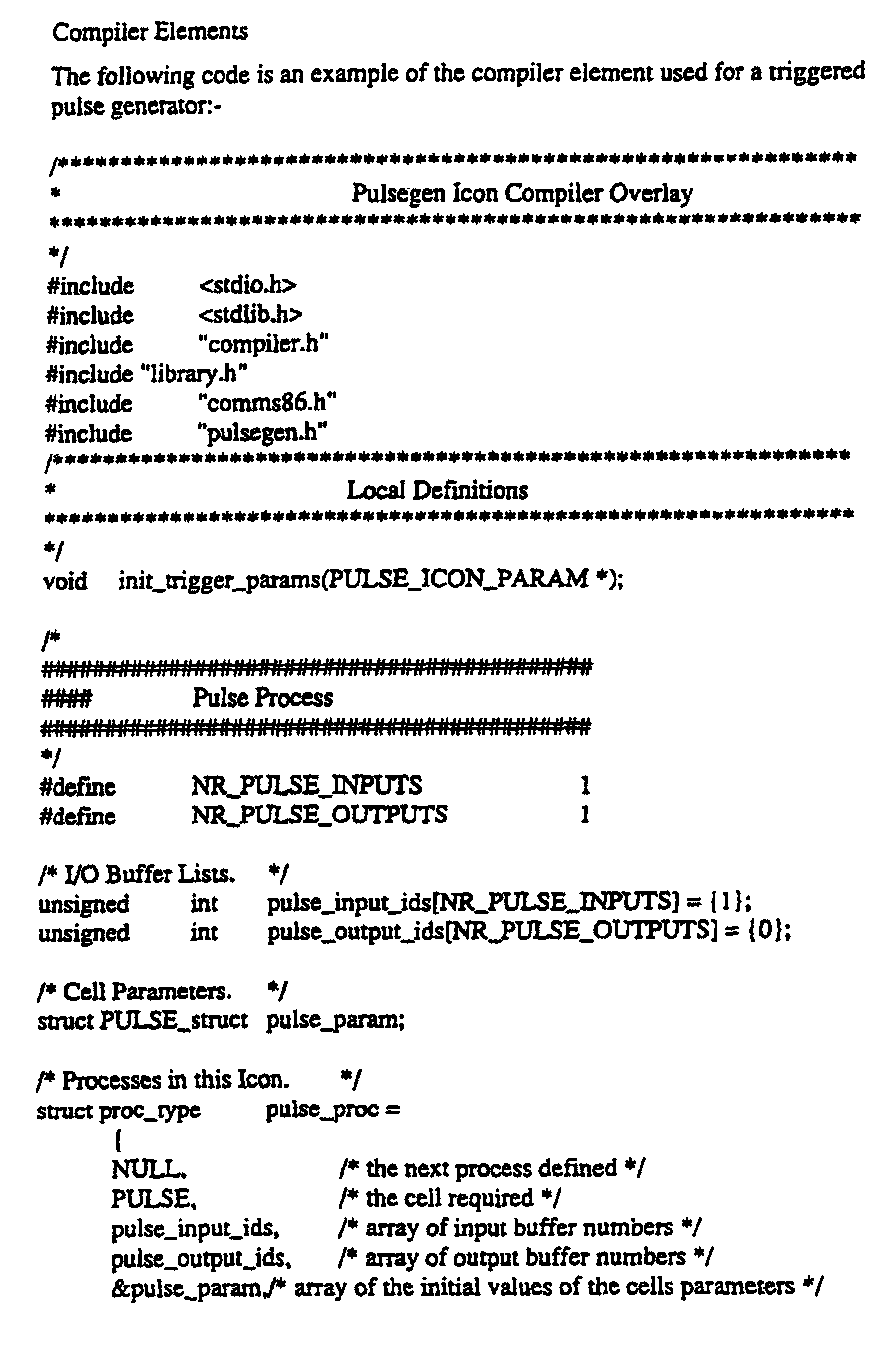

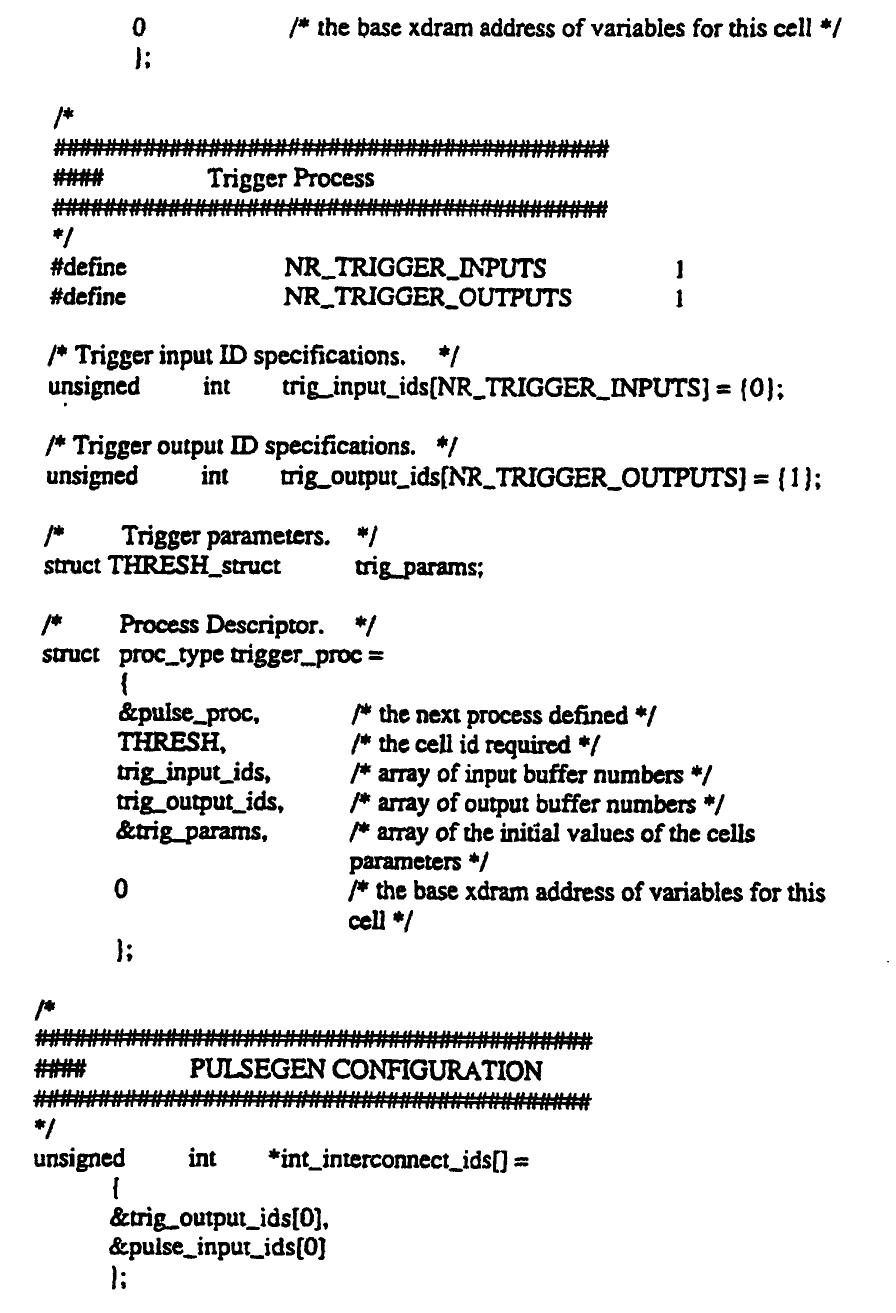

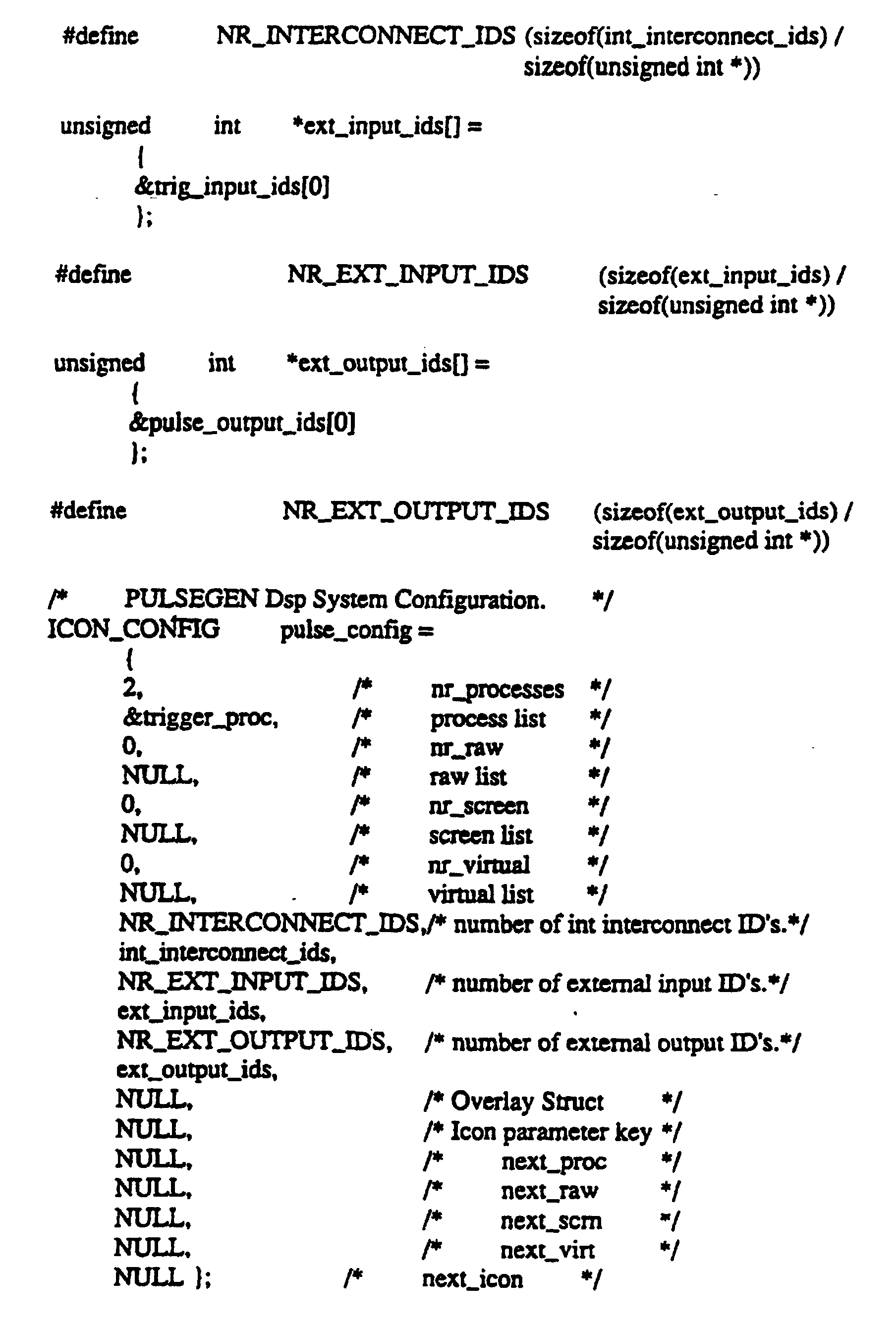

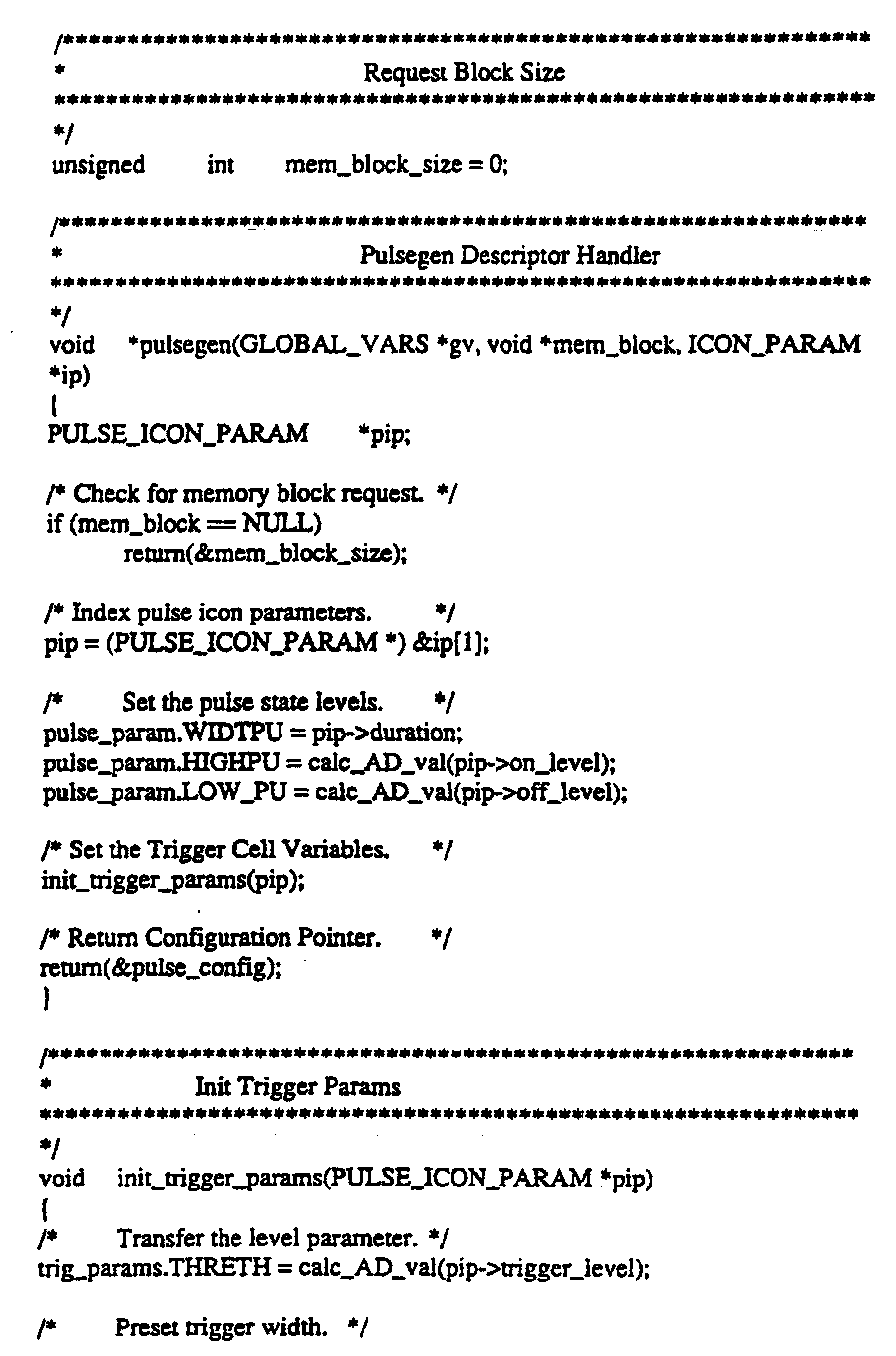

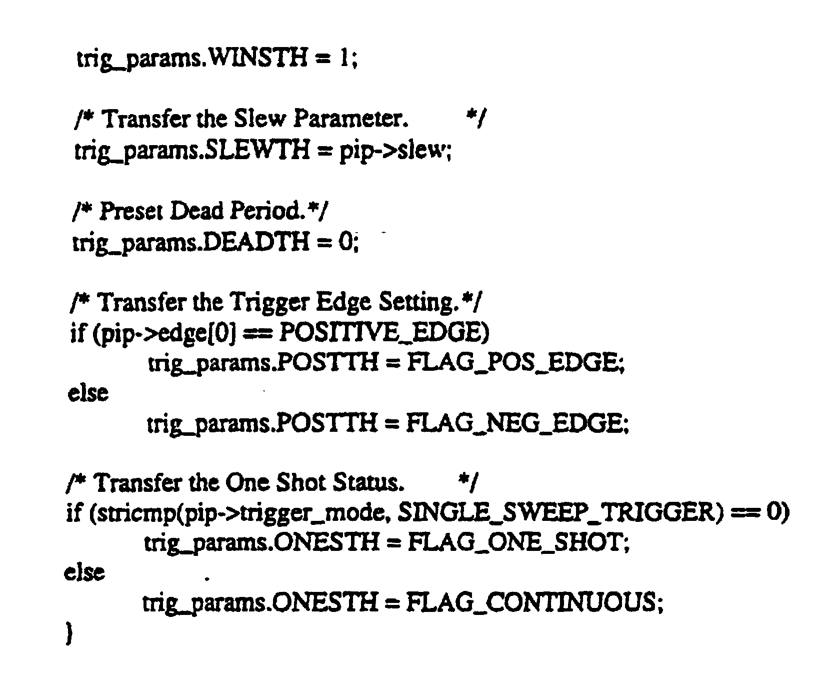

### APPENDIX III

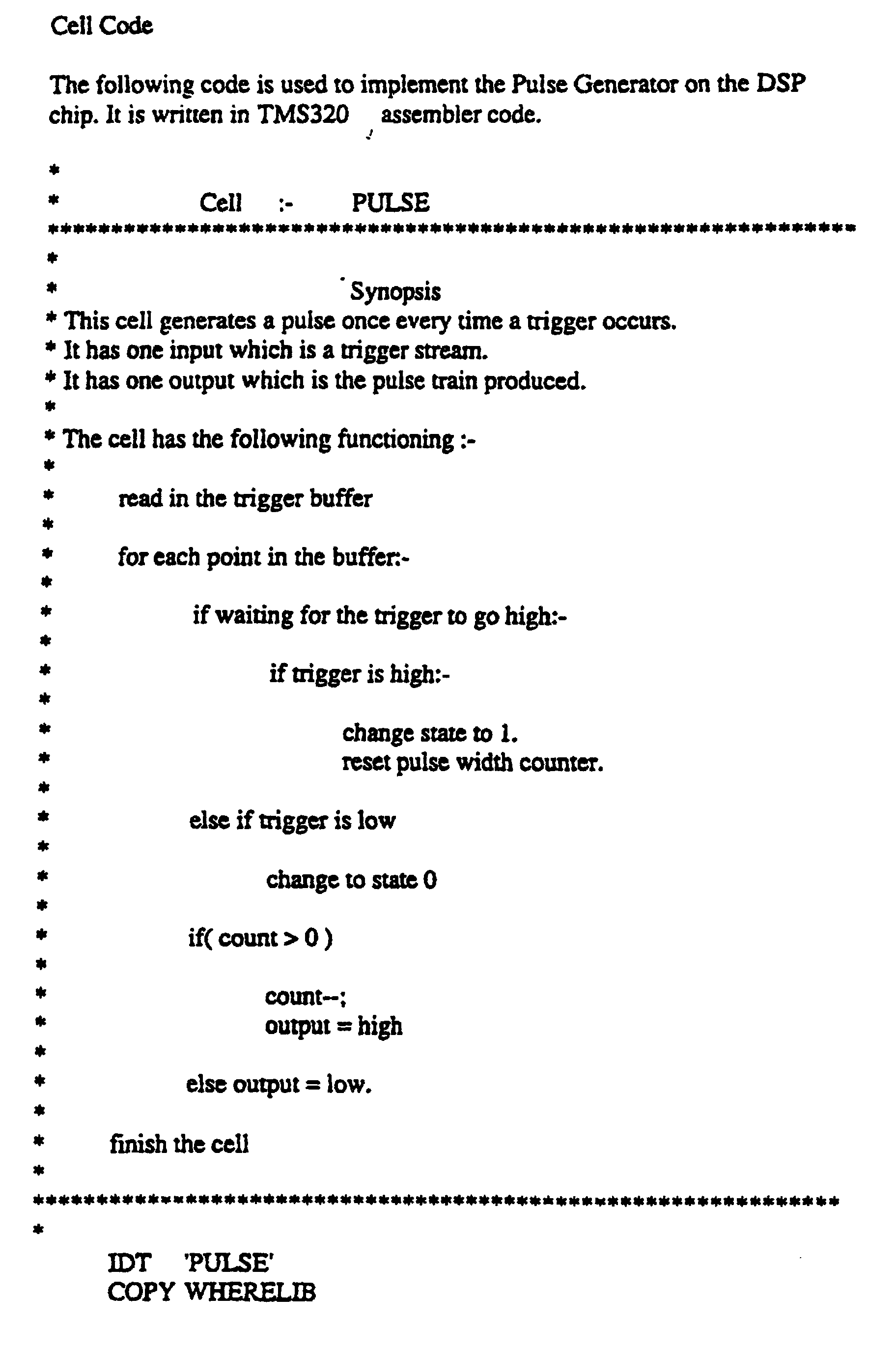

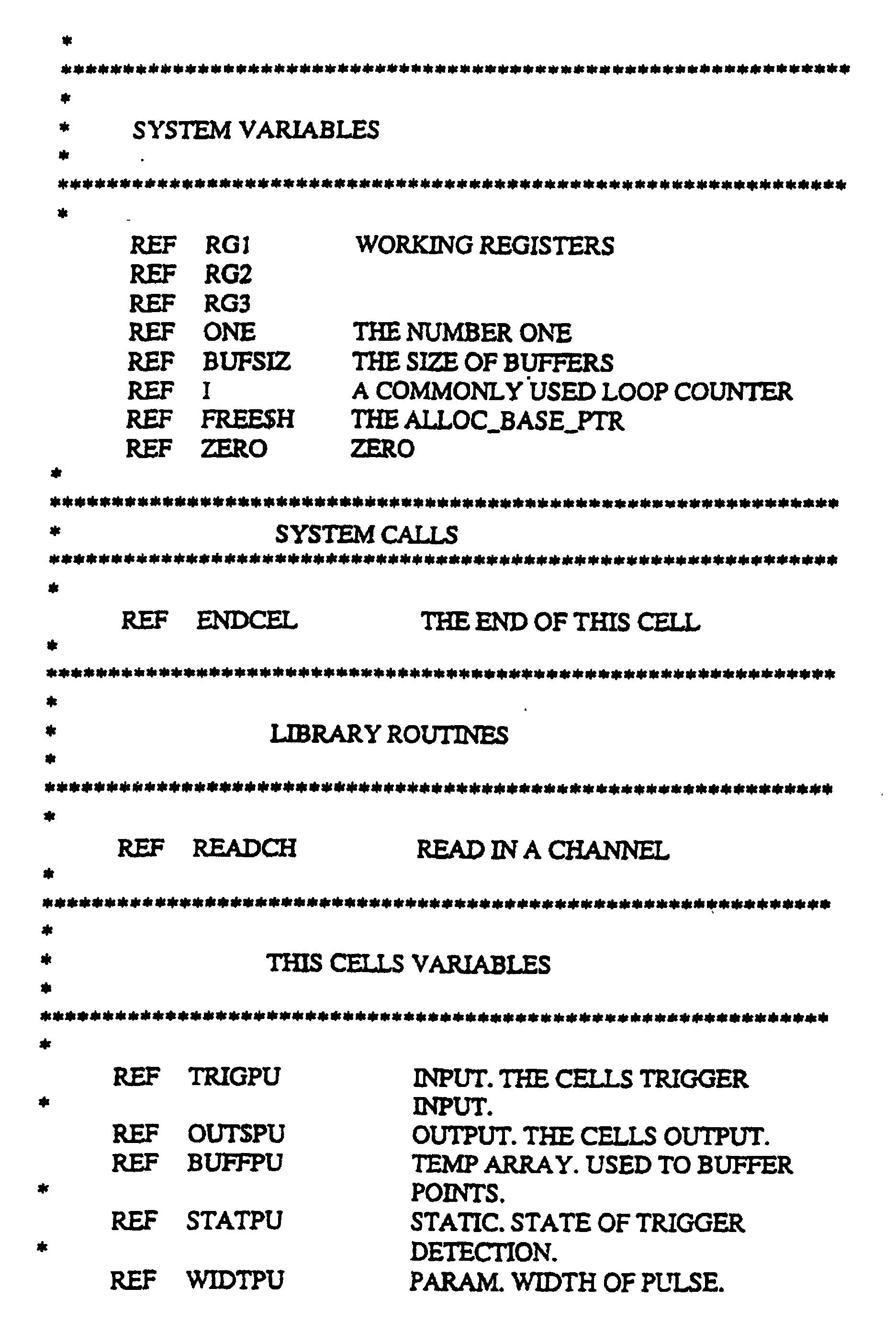

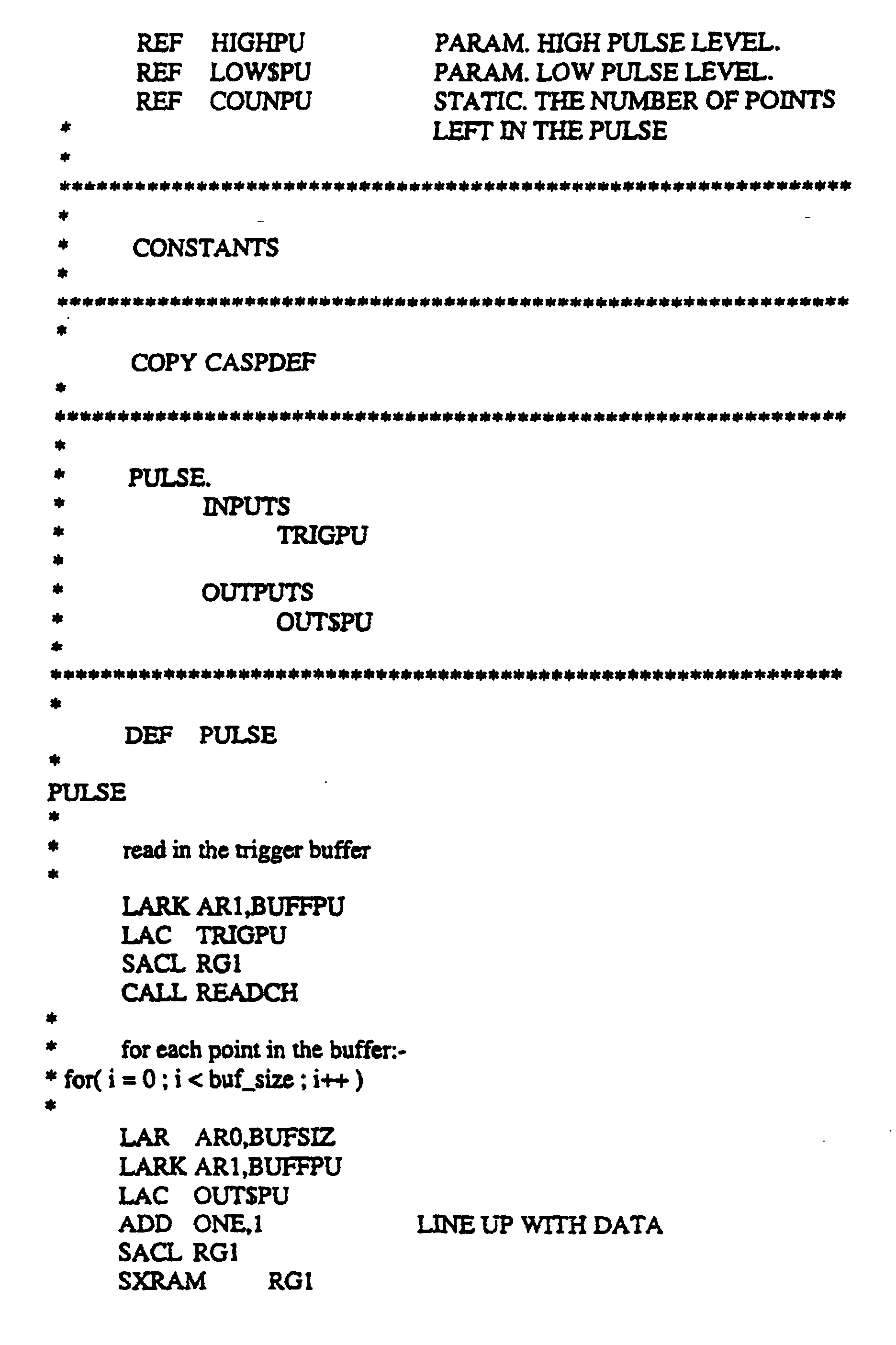

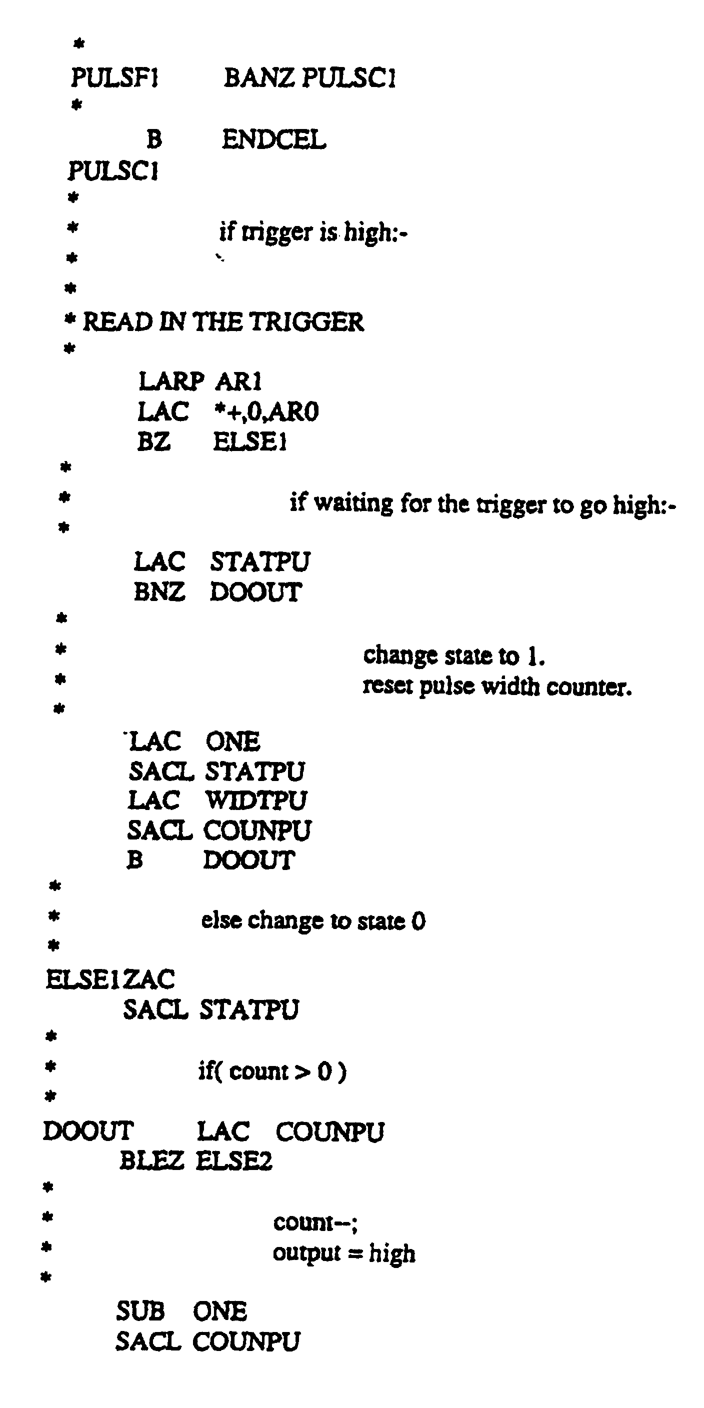

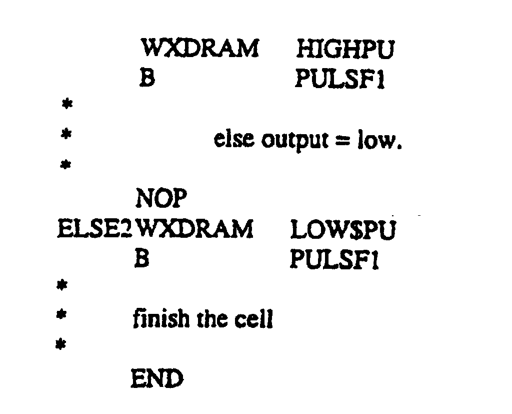

### APPENDIX IV

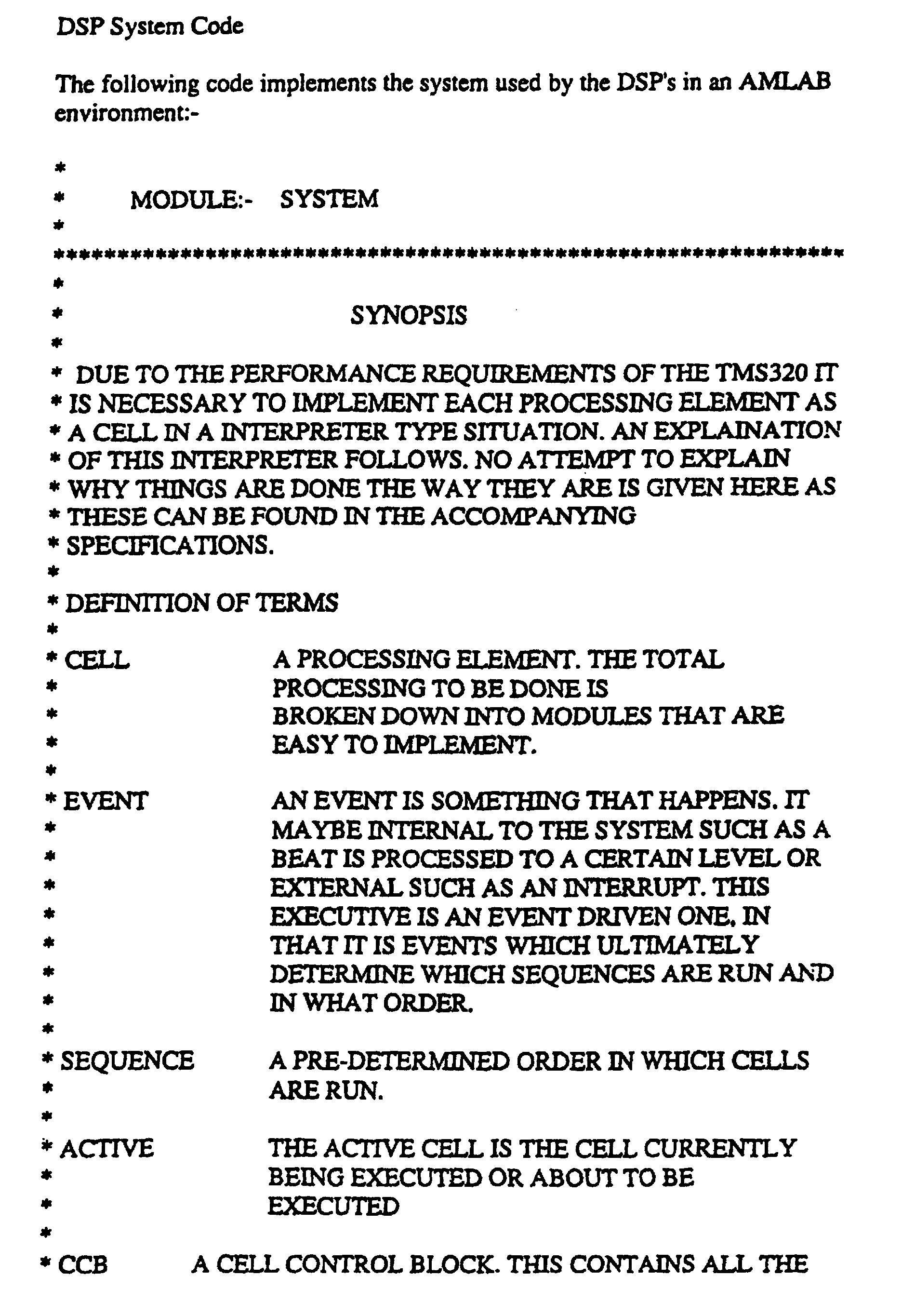

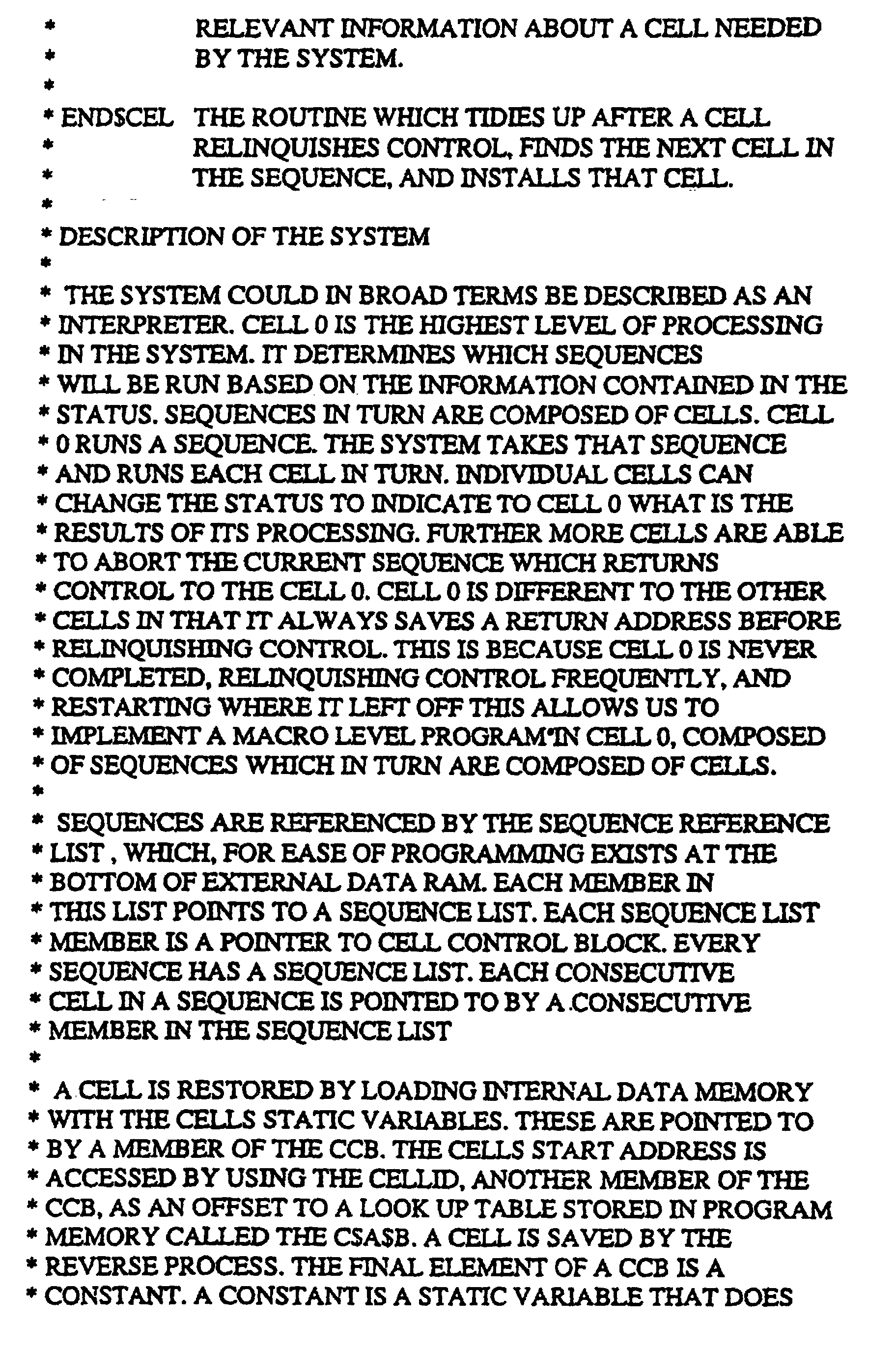

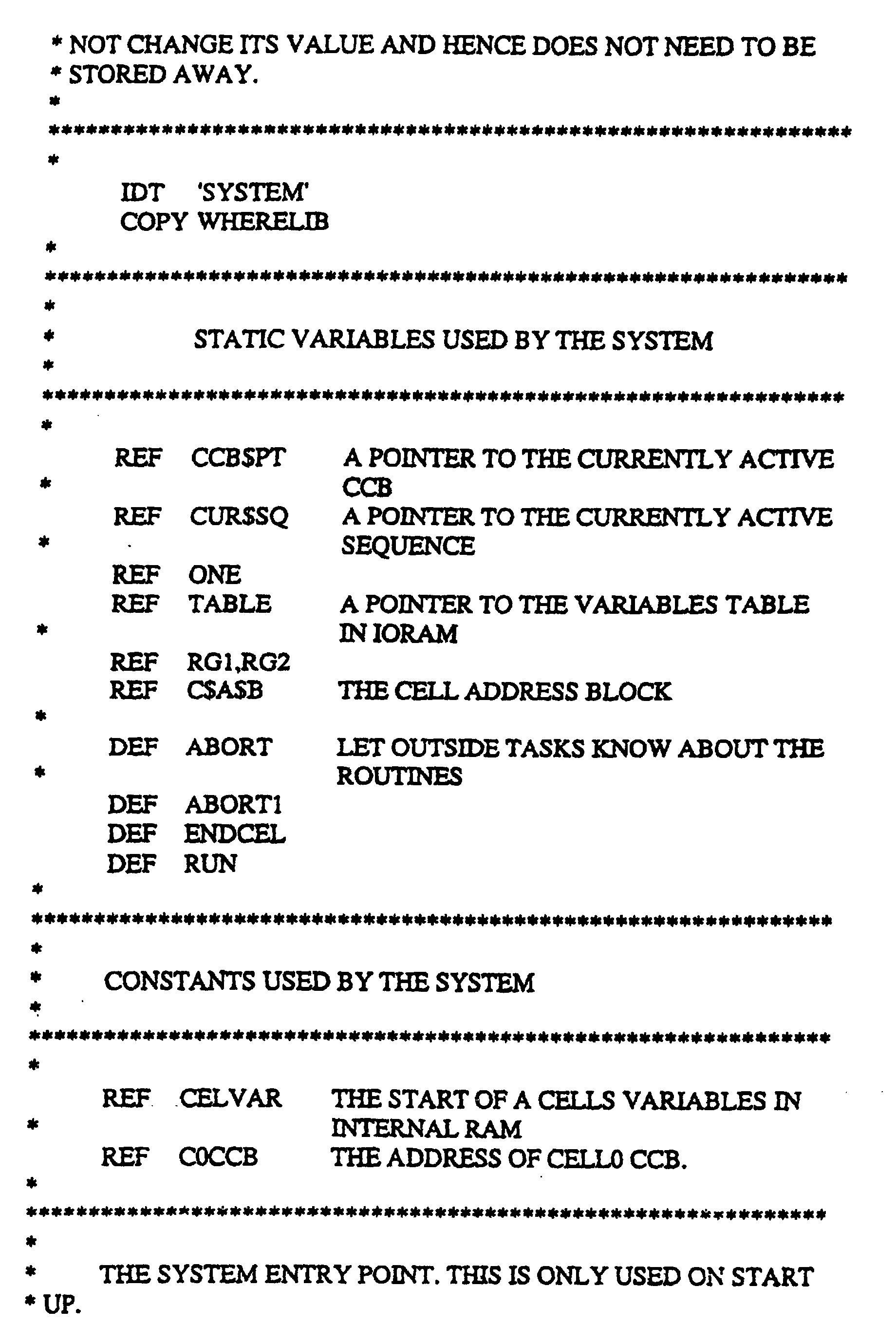

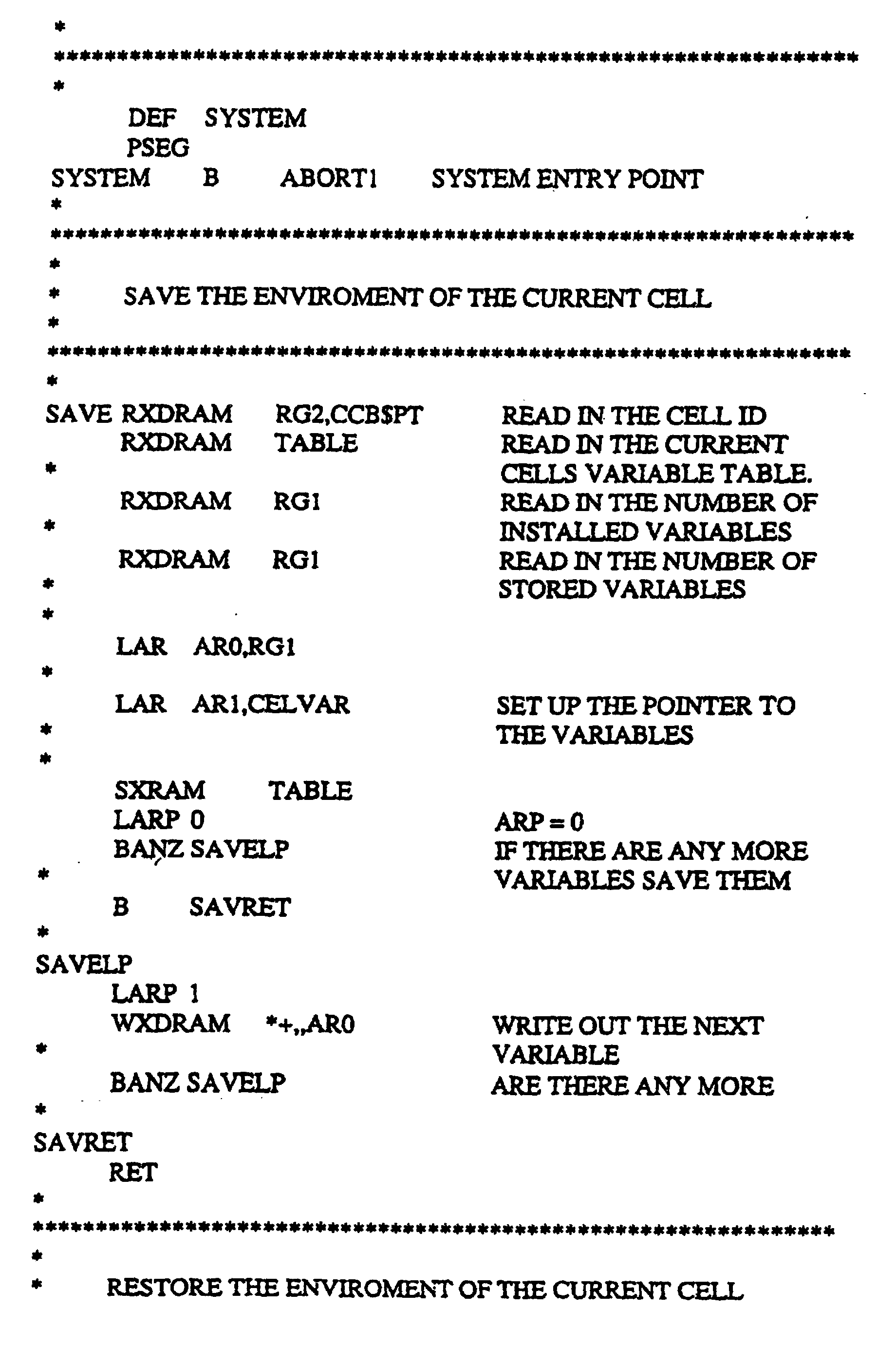

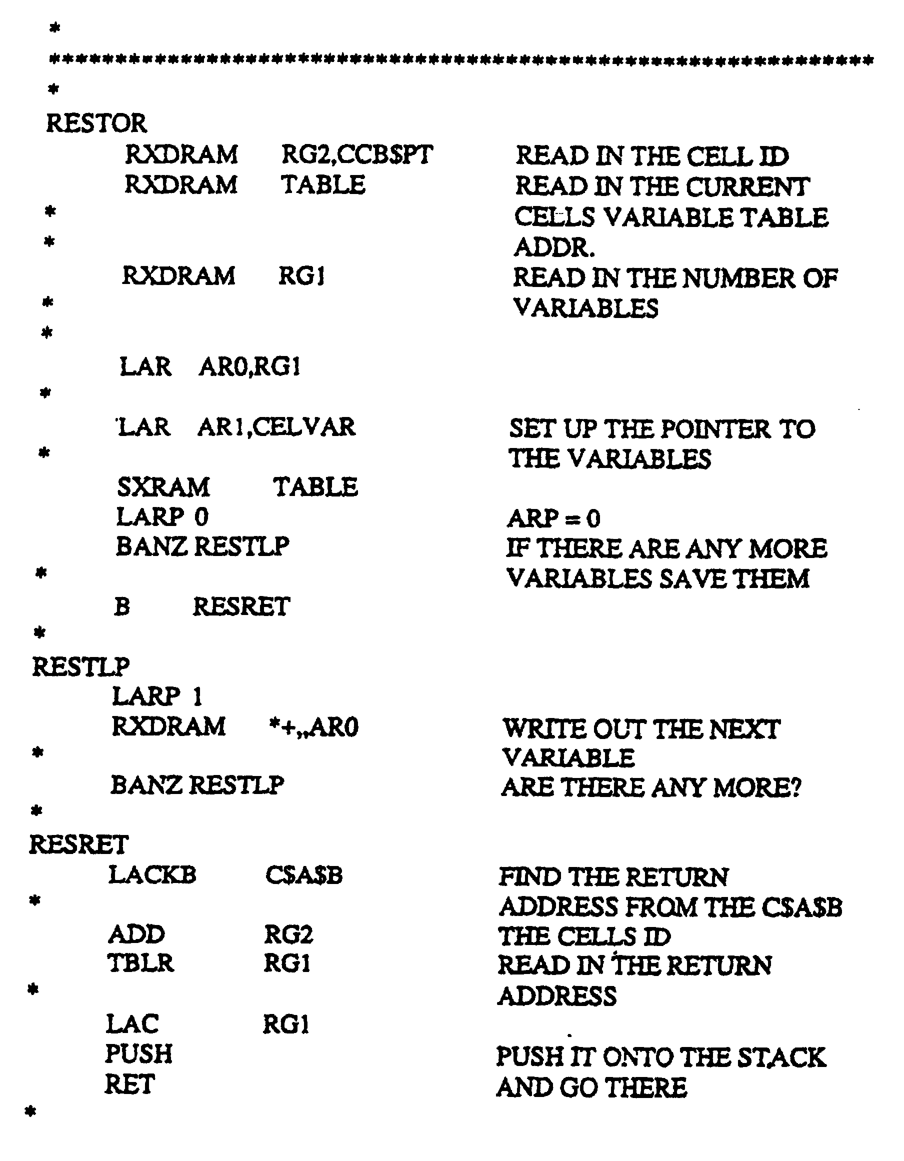

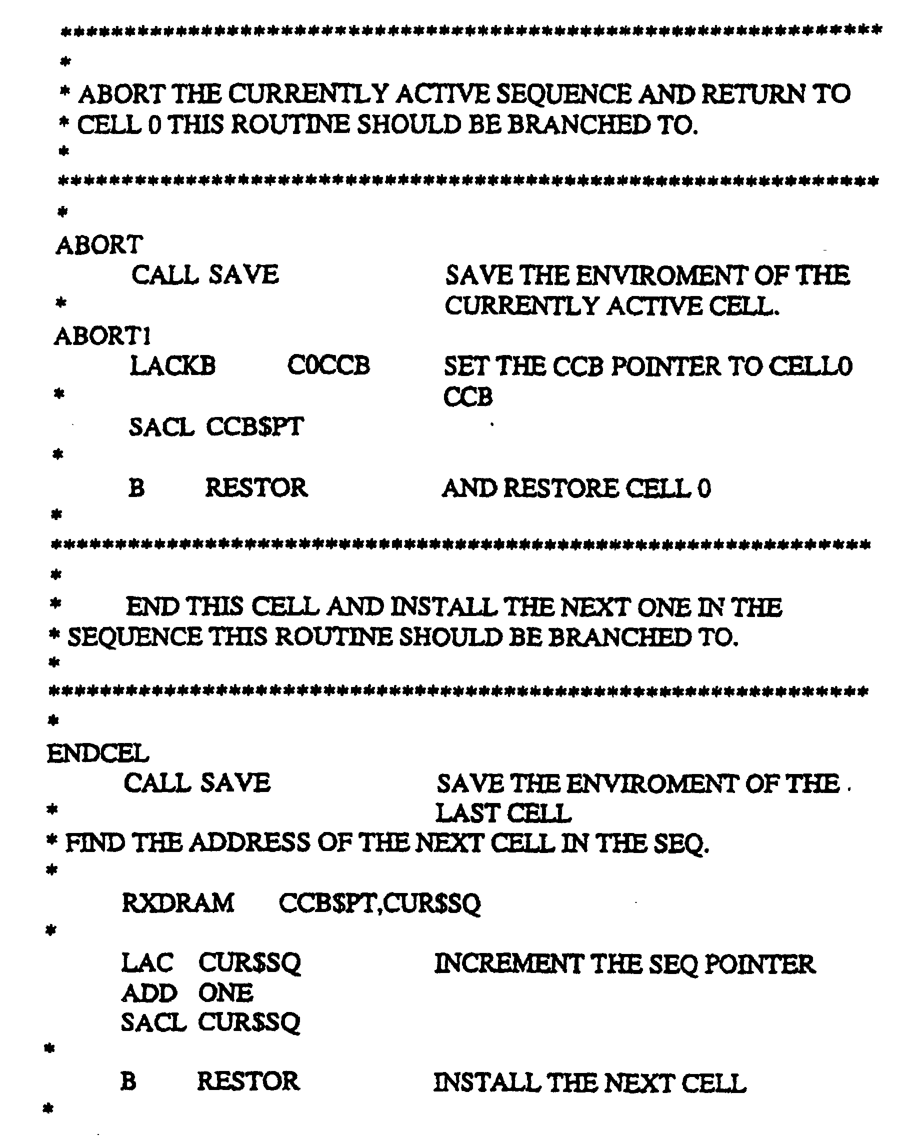

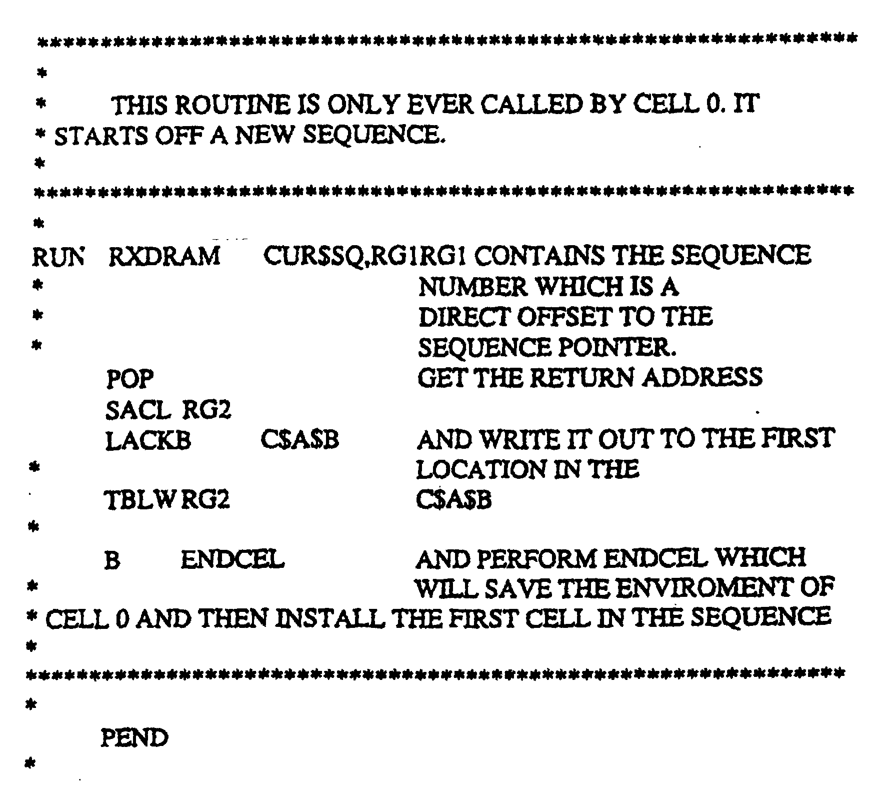

## Claims

1. A scientific instrument emulator comprising:
a computer (1) including a memory (3) coupled to a processor (2);
a multifunctional input/output signal module (6) having at least one analogue signal input (7) with digitizing means (37) connected thereto and at least one signal output (8) and being configurable with respect to at least a sampling frequency of said analogue signal input (7);
a video display (10) coupled to a video display generator (50), said video display generator (50) being coupled to said processor (2);
a library program stored in said memory (3), said library program including a plurality of instrumentation units each being able to be displayed on said video display (10) and each having a predetermined signal processing function;
a set-up program stored in said memory (3) and carried out by said processor (2) to allow an operator to interconnect selected instrumentation units to form an array of interconnected instrumentation units, wherein a sampling frequency for said multifunctional input/output signal module (6) is specified, said set-up program enables signal feedback interconnection in said array, said array having an output being provided to at least one of the following: said video display, said multifunctional input/output signal module (6) and said memory (3); and
a graphic compiler program stored in said memory (3) and executable by said processor (2) on completion of said set-up program to create a scientific instrument emulation program to carry out an overall signal processing function of said array of selected interconnected instrumentation units, said graphic compiler program being capable of resolving signal feedback in said array and to form a sequence in said emulation program of said predetermined signal processing functions of said instrument units, which are each to be carried out once between successive samples of an input signal obtained using said multifunctional input/output signal module, said emulation program containing operations configured in accordance with said specified sampling frequency for sampling said input signal to provide a data stream from said multifunctional input/output signal module (6);
an instrument emulation sub-assembly coupled to said processor (2), said memory (3) and said video display generator, wherein said instrument emulation sub-assembly is directly connected to said multifunctional input/output signal module, said instrument emulation sub-assembly having:
a second processor for executing said scientific instrument emulation program to continuously carry out said overall signal processing function so that each sample of said data stream of successive samples is processed during a single sample time to produce an array output of said scientific instrument emulator before a successive sample of said input signal is obtained by said multifunctional input/output signal module (6);
wherein at least one of a plurality of operations is performed, said plurality of operations including each of displaying said array output on said video display (10) in real time, storing said array output in the memory (3), and providing said array output to said signal output of said multifunctional input/output signal module (6) in real time.

2. The scientific instrument emulator as claimed in claim 1, wherein said instrumentation units are each represented by a corresponding icon which is able to be displayed on said video display during operation of said set-up program whereby each desired instrumentation unit can be selected, located in, and interconnected with other instrumentation units in said array.

3. The scientific instrument emulator as claimed in claim 2, wherein said array includes a data signal feedback loop connected between an output of one of said instrumentation units and an input of one said instrumentation units.

4. The scientific instrument emulator as claimed in claim 1, wherein said multifunctional input/output signal module includes an additional signal output for connection to external hardware and that is available as a real time electric signal able to operate, or trigger, said external hardware.

5. The scientific instrument emulator as claimed in claim 4, wherein said multifunctional input/output signal module has both analogue and digital signal outputs.

6. The scientific instrument emulator as claimed in claim 4, wherein said array output stored in that memory is available for subsequent graphical manipulation and/or tabulation by said computer.

7. The scientific instrument emulator as claimed in claim 1, wherein said instrument emulation processor assembly further comprises a video generator connected to said second processor for providing a displayable representation of said array output before a succeeding sample is obtained.

8. A method for determining the execution order of predefined signal processing elements in a computer having a central processing unit (2) and electronic memory (3) to implement in real time a mathematical/signal processing function of an emulated instrument having at least one repetitively sampled signal input to form a signal output thereof, said method comprising the steps of:
applying a set-up program stored in said memory (3) and carried out by said central processing unit (2) to allow an operator to interconnect selected instrumentation units, wherein a sampling frequency for a multifunctional input/output signal module (6) is specified, said set-up program enables signal feedback interconnection in said array, said array having an output being provided to at least one of the following: a video display (10), said multifunctional input/output signal module (6) and said memory (3), each of said instrumentation units having a mathematical/signal processing function;
creating a scientific instrument emulation program using a graphic compiler program stored in said memory (3) and executable by said central processing unit (2) on completion of said set-up program, said scientific instrument emulation program carrying out said overall signal processing function of said array of selected interconnected instrumentation units;
determining an execution order of said mathematical/signal processing function including the steps of:
representing said function as a sequence of elemental mathematical steps in turn representable using predefined signal processing elements, and
arranging the pre-defined signal processing elements in said sequence for sequential execution within the time between successive samples and
commencing with said at least one sampled signal input,
wherein said determining step thereby forms an array of instrumentation units having said overall circuit mathematical/signal processing function; carrying out said overall signal processing function so that each sample of said contiguous data stream is processed during a single sample time to produce an array output of said overall mathematical signal processing function before a successive sample of said input signal is obtained by said multifunctional input/output signal module (6);
representing said overall circuit mathematical/signal processing function as a sequence of events representable as predefined signal processing element events;
arranging said predefined signal processing element events in said sequence for sequential execution commencing with said at least one sampled array signal input, whereby a determinate computation time of the predefined signal processing elements is ensured by executing every one of said predefined signal processing elements once between successive samples, whereby said method is capable of resolving data signal feedback in said array of instrumentation units;
displaying said array output on said video display (10) in real time;
storing said array output in the memory (3); and
providing said array output to said signal output of said multifunctional input/output signal module in real time.

9. The method as claimed in claim 8, wherein a parameter of said functional block is able to be specified.

10. The method as claimed in claim 8, wherein said array includes at least one data signal feedback loop in which an output of one of said instrumentation units is connected to form an input of one of said plurality of instrumentation units, and an initial result of corresponding one of said executable events in said sequence of executable events is utilized in a repeated execution of an earlier event to generate a modified result of said corresponding one of said executable events from a previous sample period.

## Patentansprüche

1. Wissenschaftlicher Instrumentenemulator, aufweisend:
einen Computer (1) mit einem Speicher (3), der mit einem Prozessor (2) gekoppelt ist;
ein multifunktionales Eingangs-/Ausgangs-Signalmodul (6), welches zumindest einen analogen Signaleingang (7) mit Digitalisierungsmitteln (37) hierzu verbunden und zumindest einen Signalausgang (8) aufweist und konfigurierbar ist mit Bezug auf zumindest eine Abtastfrequenz des analogen Signaleingangs (7);
eine Videoanzeige (10), die mit einem Videoanzeigegenerator (50) gekoppelt ist, wobei der Videoanzeigegenerator (50) mit dem Prozessor (2) gekoppelt ist;
ein Bibliotheksprogramm, das in dem Speicher (3) gespeichert ist, wobei das Bibliotheksprogramm eine Mehrzahl von Instrumentationseinheiten aufweist, wobei jede geeignet ist, auf der Videoanzeige (10) angezeigt zu werden, und jede eine vorbestimmte Signalverarbeitungsfunktion aufweist, ein Set-Up-Programm, das in dem Speicher (3) gespeichert ist, und durch den Prozessor (2) ausgeführt wird, um einem Bediener zu erlauben, ausgewählte Instrumentationseinheiten miteinander zu verbinden, um ein Feld von miteinander verbundenen Instrumentationseinheiten zu bilden, wobei eine Abtastfrequenz für das multifunktionale Eingangs-/Ausgangs-Signalmodul (6) spezifiziert ist, wobei das Set-Up-Programm Signalrückführungsverbindung in dem Feld ermöglicht, wobei das Feld einen Ausgang aufweist, der zumindest einem der folgenden zugeführt wird: der Videoanzeige, dem multifunktionalen Eingangs-/Ausgangssignalmodul (6) und dem Speicher (3); und
ein graphisches Compiler-Programm, das in dem Speicher (3) gespeichert ist und durch den Prozessor (2) ausführbar ist bei Vollendung des Set-Up-Programms, um ein wissenschaftliches Instrumentationsemulationsprogramm zu kreieren, um eine Gesamt-Signalverarbeitungsfunktion des Feldes von ausgewählten verbundenen Instrumentationseinheiten auszuführen, wobei das graphische Compiler-Programm in der Lage ist, Signalrückkopplung in dem Feld aufzulösen und eine Sequenz zu bilden in dem Emulationsprogramm der vorbestimmten Signalverarbeitungsfunktionen der Instrumentationseinheiten, die jede auszuführen ist einmal zwischen sukzessiven Samples eines Eingangssignals, das erhalten wird unter Verwendung des multifunktionalen Eingangs-/Ausgangssignalmoduls, wobei das Emulationsprogramm Operationen aufweist, die gemäß der spezifizierten Abtastfrequenz konfiguriert sind, zum Abtasten des Eingangssignals, um einen Datenstrom von dem multifunktionalen Eingangs-/Ausgangssignalmodul (6) zu schaffen;
eine Instrumentenemulationsunteranordnung, die gekoppelt ist mit dem Prozessor (2), dem Speicher (3) und dem Videoanzeigegenerator, wobei die Instrumentenemulationsunteranordnung direkt verbunden ist mit dem multifunktionalen Eingangs-/Ausgangs-Signalmodul, wobei die Instrumentenemulationsunteranordnung aufweist:
einen zweiten Prozessor zum Ausführen des wissenschaftlichen Instrumentenemulationsprogramms, um kontinuierlich die Gesamt-Signalverarbeitungsfunktion auszuführen, derart, dass jedes Sample des Datenstroms von sukzessiven Samples verarbeitet wird während einer einzelnen Sample-Zeit, um eine Feldausgabe des wissenschaftlichen Instrumentenemulators zu produzieren, bevor ein sukzessives Sample des Eingangssignals erhalten wird durch das multifunktionale Eingangs-/Ausgangssignalmodul (6);
wobei zumindest eine einer Mehrzahl von Operationen durchgeführt wird, wobei die Mehrzahl von Operationen jede von Anzeigen der Feldausgabe auf der Videoanzeige (10) in Echtzeit, Speichern der Feldausgabe in dem Speicher (3) und Bereitstellen der Feldausgabe zu dem Signalausgang des multifunktionalen Eingangs-/Ausgangssignalmoduls (6) in Echtzeit umfasst.

2. Wissenschaftlicher Instrumentenemulator gemäß Anspruch 1, bei welchem die Instrumentationseinheiten jede repräsentiert sind durch ein entsprechendes Icon, welches geeignet ist, auf der Videoanzeige angezeigt zu werden während des Betriebs des Set-Up-Programms, wobei jede gewünschte Instrumentatinseinheit ausgewählt werden kann, die angeordnet ist in und verbunden ist mit anderen Instrumentationseinheiten in dem Feld.

3. Wissenschaftlicher Instrumentenemulator gemäß Anspruch 2, bei welchem das Feld eine Datensignal-Rückkopplungsschleife aufweist, die zwischen einem Ausgang einer der Instrumentationseinheiten und einem Eingang einer der Instrumentationseinheiten verbunden ist.

4. Wissenschaftlicher Instrumentenemulator gemäß Anspruch 1, bei welchem das multifunktionale Eingangs-/Ausgangssignalmodul einen zusätzlichen Signalausgang aufweist zur Verbindung mit externer Hardware und welcher verfügbar ist als ein Echtzeit-elektrisches Signal, welches geeignet ist, die externe Hardware zu bedienen oder zu triggern.

5. Wissenschaftlicher Instrumentenemulator gemäß Anspruch 4, bei welchem das multifunktionale Eingangs-/Ausgangssignalmodul sowohl analoge als auch digitale Signalausgänge aufweist.

6. Wissenschaftlicher Instrumentenemulator gemäß Anspruch 4, bei welchem die Feldausgabe, die in dem Speicher gespeichert wird, verfügbar ist für nachfolgende graphische Manipulation und/oder Tabulation durch den Computer.

7. Wissenschaftlicher Instrumentenemulator gemäß Anspruch 1, bei welchem die Instrumentenemulations-Prozessoranordnung des Weiteren einen Videogenerator aufweist, der mit dem zweiten Prozessor verbunden ist, zum Bereitstellen einer anzeigbaren Repräsentation der Feldausgabe, bevor ein nachfolgendes Sample erhalten wird.

8. Verfahren zum Bestimmen der Ausführungsreihenfolge vorbestimmter Signalverarbeitungselemente in einem Computer, der eine Zentralverarbeitungseinheit (2) und einen elektronischen Speicher (3) aufweist, um in Echtzeit eine mathematische/Signalverarbeitungsfunktion eines emulierten Instruments zu implementieren, welches zumindest eine wiederholt abgetastete Signaleingabe aufweist, um davon eine Signalausgabe zu bilden, wobei das Verfahren die folgenden Schritte aufweist:
Anwenden eines Set-Up-Programms, welches in dem Speicher (3) gespeichert wird und durch die Zentralverarbeitungseinheit (2) ausgerührt wird, um einem Bediener zu erlauben, ausgewählte Instrumentationseinheiten miteinander zu verbinden, wobei eine Abtastfrequenz für ein multifunktionales Eingangs-/Ausgangssignalmodul (6) spezifiziert wird, wobei das Set-Up-Programm Rückkopplungsverbindung in dem Feld ermöglicht, wobei das Feld einen Ausgang aufweist, welcher zumindest einem der folgenden zugeführt wird: einer Videoanzeige (10), dem multifunktionalen Eingangs-/Ausgangssignalmodul (6) und dem Speicher (3), wobei jede der Instrumentationseinheiten eine mathematische/Signalverarbeitungsfunktion aufweist;
Kreieren eines wissenschaftlichen Instrumentenemulationsprogramms unter Verwendung eines Compiler-Programms, welches in dem Speicher (3) gespeichert wird und durch die Zentralverarbeitungseinheit (2) bei Vollendung des Set-Up-Programms ausführbar ist, wobei das wissenschaftliche Instrumentenemulationsprogramm die Gesamt-Signalverarbeitungsfunktion des Feldes ausgewählter verbundener Instrumentationseinheiten ausführt,
Bestimmen einer Ausführungsreihenfolge der mathematischen/Signalverarbeitungsfunktion mit den folgenden Schritten:
Repräsentieren der Funktion als eine Sequenz elementarer mathematischer Schritte, die ihrerseits repräsentierbar sind unter Verwendung vordefinierter Signalverarbeitungselemente, und
Anordnen der vorbestimmten Signalverarbeitungselemente in der Sequenz für sequentielle Ausführung innerhalb der Zeit zwischen sukzessiven Samples und Beginnen mit der zumindest einen abgetasteten Signaleingabe,
wobei der Bestimmungsschritt hierdurch ein Feld von Instrumentationseinheiten bildet, welches die Gesamtschaltungsmathematische/Signalverarbeitungsfunktion aufweist;
Ausführen der Gesamt-Signalverarbeitungsfunktion, derart, dass jedes Sample des zusammenhängenden Datenstroms verarbeitet wird während einer einzelnen Abtastzeit, um eine Feldausgabe der gesamtmathematischen Signalverarbeitungsfunktion zu produzieren, bevor ein sukzessives Sample des Eingangssignals erhalten wird durch das multifunktionale Eingangs-/Ausgangssignalmodul (6);
Repräsentieren der Gesamtschaltungsmathematischen/Signalverarbeitungsfunktion als eine Sequenz von Ereignissen, die darstellbar sind als vorbestimmte Signalverarbeitungselementereignisse;
Anordnen der vorbestimmten Signalverarbeitungselementereignisse in der Sequenz für sequentielle Ausführung, beginnend mit der zumindest einen abgetasteten Feldsignaleingabe, wobei eine bestimmte Rechnerzeit der vorbestimmten Signalverarbeitungselemente gesichert wird durch Ausführen jedes der vorbestimmten Signalverarbeitungselemente einmal zwischen sukzessiven Samples, wobei das Verfahren in der Lage ist, Datensignal-Rückkopplung in dem Feld von Instrumentationseinheiten aufzulösen;
Anzeigen der Feldausgabe auf der Videoanzeige (10) in Echtzeit;
Speichern der Feldausgabe in dem Speicher (3); und
Bereitstellen der Feldausgabe an den Signalausgang des multifunktionalen Eingangs-/Ausgangssignalmoduls in Echtzeit.

9. Verfahren gemäß Anspruch 8, bei welchem ein Parameter des funktionalen Blocks spezifiziert werden kann.

10. Verfahren gemäß Anspruch 8, bei welchem das Feld zumindest eine Datensignal-Rückkopplungsschleife umfasst, in welcher ein Ausgang von einer der Instrumentationseinheiten verbunden ist, um einen Eingang von einer der Mehrzahl von Instrumentationseinheiten zu bilden, und ein ursprüngliches Ergebnis eines entsprechenden der ausführbaren Ereignisse in der Sequenz ausführbarer Ereignisse verwendet wird in einer wiederholten Ausführung eines früheren Ereignisses, um ein modifiziertes Ergebnis des entsprechenden einen der ausführbaren Ereignisse von einer vorherigen Abtastperiode zu erzeugen.

## Revendications

1. Emulateur d'instrument scientifique comportant :
un ordinateur (1) incluant une mémoire (3) couplée à un processeur (2),
un module d'entrée/sortie de signal multifonctionnel (6) ayant au moins une entrée de signal analogique (7) ayant des moyens de numérisation (37) qui lui sont connectés et au moins une sortie de signal (8) et étant configurable par rapport à au moins une fréquence d'échantillonnage de ladite entrée de signal analogique (7),
un affichage vidéo (10) couplé à un générateur d'affichage vidéo (50), ledit générateur d'affichage vidéo (50) étant couplé audit processeur (2),
un programme de bibliothèque mémorisé dans ladite mémoire (3), ledit programme de bibliothèque incluant une pluralité d'unités d'instrumentation chacune pouvant être affichées sur ledit affichage vidéo (10) et ayant chacune une fonction de traitement de signal prédéterminée,
un programme d'initialisation mémorisé dans ladite mémoire (3) et exécuté par ledit processeur (2) pour permettre à un opérateur d'interconnecter des unités d'instrumentation sélectionnées pour former un ensemble d'unités d'instrumentation interconnectées, dans lequel une fréquence d'échantillonnage dudit module d'entrée/sortie de signal multifonctionnel (6) est spécifiée, ledit programme d'initialisation permet une interconnexion à rétroaction de signal dans ledit ensemble, ledit ensemble ayant une sortie fournie à au moins l'un des éléments suivants : ledit affichage vidéo, ledit module d'entrée/sortie de signal multifonctionnel (6) et ladite mémoire (3), et
un programme de compilateur graphique mémorisé dans ladite mémoire (3) et exécutable par ledit processeur (2) à la fin dudit programme d'initialisation pour créer un programme d'émulation d'instrument scientifique permettant d'exécuter une fonction de traitement de signal complète dudit ensemble d'unités d'instrumentation interconnectées sélectionnées, ledit programme de compilateur graphique étant capable de résoudre une rétroaction de signal dudit ensemble et de former une séquence dans ledit programme d'émulation desdites fonctions de traitement de signal prédéterminées desdites unités d'instrument, qui doivent être chacune exécutées une fois entre des échantillons successifs d'un signal d'entrée obtenu en utilisant ledit module d'entrée/sortie de signal multifonctionnel, ledit programme d'émulation contenant des opérations configurées conformément à ladite fréquence d'échantillonnage spécifiée pour échantillonner ledit signal d'entrée afin de fournir un flot de données à partir dudit module d'entrée/sortie de signal multifonctionnel (6),
un sous-groupe d'émulation d'instrument couplé audit processeur (2), à ladite mémoire (3) et audit générateur d'affichage vidéo, où ledit sous-groupe d'émulation d'instrument est directement connecté audit module d'entrée/sortie de signal multifonctionnel, ledit sous-groupe d'émulation d'instrument ayant : un second processeur pour exécuter ledit programme d'émulation d'instrument scientifique pour réaliser en continu ladite fonction de traitement de signal complète de telle sorte que chaque échantillon dudit flot de données d'échantillons successifs est traité pendant une seule durée d'échantillon pour produire une sortie d'ensemble dudit émulateur d'instrument scientifique avant qu'un échantillon successif dudit signal d'entrée ne soit obtenu par ledit module d'entrée/sortie de signal multifonctionnel (6),
dans lequel au moins l'une d'une pluralité d'opérations est effectuée, ladite pluralité d'opérations incluant chacune l'affichage de ladite sortie d'ensemble sur ledit affichage vidéo (10) en temps réel, la mémorisation de ladite sortie d'ensemble dans la mémoire (3), et l'envoi de ladite sortie d'ensemble à ladite sortie de signal dudit module d'entrée/sortie de signal multifonctionnel (6) en temps réel.

2. Emulateur d'instrument scientifique selon la revendication 1, dans lequel lesdits unités d'instrumentation sont chacune représentées par une icône correspondante qui peut être affichée sur ledit affichage vidéo pendant l'exécution dudit programme d'initialisation par lequel chaque unité d'instrumentation souhaitée peut être sélectionnée, localisée, et interconnectée avec d'autres unités d'instrumentation dudit ensemble.

3. Emulateur d'instrument scientifique selon la revendication 2, dans lequel ledit ensemble inclut une boucle de rétroaction de signal de données connectée entre une sortie de l'une desdites unités d'instrumentation et une entrée de l'une desdites unités d'instrumentation.

4. Emulateur d'instrument scientifique selon la revendication 1, dans lequel ledit module d'entrée/sortie de signal multifonctionnel inclut une sortie de signal supplémentaire à relier à un matériel externe et qui est disponible en tant que signal électrique en temps réel pouvant commander, ou déclencher, ledit matériel externe.

5. Emulateur d'instrument scientifique selon la revendication 4, dans lequel ledit module d'entrée/sortie de signal multifonctionnel a à la fois des sorties de signal analogique et numérique.

6. Emulateur d'instrument scientifique selon la revendication 4, dans lequel ladite sortie d'ensemble mémorisée dans cette mémoire est disponible pour une manipulation et/ou tabulation graphique ultérieure par ledit ordinateur.

7. Emulateur d'instrument scientifique selon la revendication 1, dans lequel ledit assemblage de processeur d'émulation d'instrument comporte en outre un générateur vidéo connecté audit second processeur pour fournir une représentation affichable de ladite sortie d'ensemble avant d'obtenir un échantillon suivant.

8. Procédé pour déterminer l'ordre d'exécution d'éléments de traitement de signal prédéfinis dans un ordinateur ayant une unité centrale de traitement (2) et une mémoire électronique (3) pour implémenter en temps réel une fonction mathématique/de traitement de signal d'un instrument émulé ayant au moins une entrée de signal échantillonnée d'une manière répétée pour former une sortie de signal de celui-ci, ledit procédé comportant les étapes consistant à :
appliquer une programme d'initialisation mémorisé dans ladite mémoire (3) et exécuté par ladite unité centrale de traitement (2) pour permettre à un opérateur d'interconnecter des unités d'instrumentation sélectionnées, dans lequel une fréquence d'échantillonnage d'un module d'entrée/sortie de signal multifonctionnel (6) est spécifiée, ledit programme d'initialisation permet l'interconnexion à rétroaction de signal dans ledit ensemble, ledit ensemble ayant une sortie fournie à au moins l'un des éléments suivants : l'affichage vidéo (10), ledit module d'entrée/sortie de signal multifonctionnel (6) et ladite mémoire (3), chacune desdites unités d'instrumentation ayant une fonction mathématique/de traitement de signal,
créer un programme d'émulation d'instrument scientifique en utilisant un programme de compilateur graphique mémorisé dans ladite mémoire (3) et exécutable par ladite unité centrale de traitement (2) à la fin dudit programme d'initialisation, ledit programme d'émulation d'instrument scientifique réalisant ladite fonction de traitement de signal complète dudit ensemble d'unités d'instrumentation interconnectées sélectionnées,
déterminer un ordre d'exécution de ladite fonction mathématique/de traitement de signal incluant les étapes consistant à :
représenter ladite fonction sous la forme d'une séquence d'étapes mathématiques élémentaires pouvant être à leur tour représentées en utilisant des éléments de traitement de signal prédéfinis, et
organiser les éléments de traitement de signal prédéfinis en ladite séquence pour une exécution séquentielle pendant la durée entre des échantillons successifs et commencer par ladite au moins une entrée de signal échantillonnée,
dans lequel ladite étape de détermination forme ainsi un ensemble d'unités d'instrumentation ayant ladite fonction mathématique/de traitement de signal de circuit complète,
réaliser ladite fonction de traitement de signal complète de telle sorte que chaque échantillon dudit flot de données contiguës est traité pendant une seule durée d'échantillon pour produire une sortie d'ensemble de ladite fonction mathématique/de traitement de signal complète avant d'obtenir un échantillon successif dudit signal d'entrée par ledit module d'entrée/sortie de signal multifonctionnel (6),
représenter ladite fonction mathématique/de traitement de signal de circuit complète sous la forme d'une séquence d'événements représentable sous la forme d'événements d'éléments de traitement de signal prédéfinis,
organiser lesdits événements d'éléments de traitement de signal prédéfinis en ladite séquence pour une exécution séquentielle en commençant par ladite au moins une entrée de signal d'ensemble échantillonnée, de manière à ce qu'une durée de calcul déterminée des éléments de traitement de signal prédéfinis soit garantie en exécutant chacun desdits éléments de traitement de signal prédéfinis une fois entre des échantillons successifs, ainsi ledit procédé est capable de résoudre une rétroaction de signal de données dudit ensemble d'unités d'instrumentation,
afficher ladite sortie d'ensemble sur ledit affichage vidéo (10) en temps réel,
mémoriser ladite sortie d'ensemble dans la mémoire (3), et
fournir ladite sortie d'ensemble à ladite sortie de signal dudit module d'entrée/sortie de signal multifonctionnel en temps réel.

9. Procédé selon la revendication 8, dans lequel un paramètre dudit bloc fonctionnel peut être spécifié.

10. Procédé selon la revendication 8, dans lequel ledit ensemble inclut au moins une boucle de rétroaction de signal de données dans laquelle une sortie de l'une desdites unités d'instrumentation est connectée pour former une entrée d'une unité de ladite pluralité d'unités d'instrumentation, et un résultat initial d'un événement correspondant parmi lesdits événements exécutables de ladite séquence événements exécutables est utilisé dans une exécution répétée d'un événement antérieur pour générer un résultat modifié dudit événement correspondant parmi lesdits événements exécutables à partir d'une précédente période d'échantillon.
